(19) **Europäisches Patentamt / European Patent Office / Office européen des brevets**

(11) **EP 2 286 515 B1**

(12) **EUROPÄISCHE PATENTSCHRIFT**

(45) Veröffentlichungstag und Bekanntmachung des Hinweises auf die Patenterteilung:
**01.02.2012 Patentblatt 2012/05**

(21) Anmeldenummer: **09761502.5**

(22) Anmeldetag: **12.06.2009**

(51) Int Cl.:
**H03M 1/06** *(2006.01)*   *H03M 1/46* *(2006.01)*
**H03M 1/20** *(2006.01)*

(86) Internationale Anmeldenummer:
**PCT/EP2009/004219**

(87) Internationale Veröffentlichungsnummer:
**WO 2009/149939 (17.12.2009 Gazette 2009/51)**

(54) **ANALOG/DIGITALWANDLER MIT EINER SAR-TOPOLOGIE SOWIE ZUGEHÖRIGES VERFAHREN**

ANALOG/DIGITAL CONVERTER HAVING AN SAR TOPOLOGY, AND ASSOCIATED METHOD

CONVERTISSEUR ANALOGIQUE-NUMÉRIQUE À TOPOLOGIE SAR ET PROCÉDÉ ASSOCIÉ

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **12.06.2008 DE 102008027939**

(43) Veröffentlichungstag der Anmeldung:
**23.02.2011 Patentblatt 2011/08**

(73) Patentinhaber: **Rutronik Elektronische Bauelemente GmbH**
**75228 Ispringen (DE)**

(72) Erfinder: **MANGLER, Andreas**
**76228 Karlsruhe (DE)**

(74) Vertreter: **Reinhardt, Harry**
**Reinhardt & Pohlmann Partnerschaft**
**Grünstrasse 1**
**75172 Pforzheim (DE)**

(56) Entgegenhaltungen:
**DE-C1- 4 318 728    US-B1- 6 448 912**

- **YAZICIOGLU R F ET AL: "A 200 uW Eight-Channel Acquisition ASIC for Ambulatory EEG Systems" 3. Februar 2008 (2008-02-03), SOLID-STATE CIRCUITS CONFERENCE, 2008. ISSCC 2008. DIGEST OF TECHNICAL PAPERS. IEEE INTERNATIONAL, IEEE, PISCATAWAY, NJ, USA, PAGE(S) 164 - 603 , XP031440499 ISBN: 9781424420100 Seite 1; Abbildung 8.2.1**
- **"Tutorial: Analog Data Acquisition Technology Part IV-System Design, Analysis, and Performance" IEEE MICRO, IEEE SERVICE CENTER, LOS ALAMITOS, CA, US, Bd. 1, Nr. 1, 1. Februar 1983 (1983-02-01) , Seiten 52-61, XP011158220 ISSN: 0272-1732**
- **Analog Devices: "CMOS, +1.8 V to +5.5 V / ±2.5 V, 2.5 Ohm Low-Voltage, 8-/16-Channel Multiplexers ADG706/ADG707" 31. Mai 2002 (2002-05-31), XP002556474 Gefunden im Internet: URL:http://www.analog.com/static/imported-files/Data_Sheets/ADG706_707.pdf> [gefunden am 2009-11-20]**

**Beschreibung**

Die Erfindung betrifft einen Analog/Digitalwandler zur Absolutmesswertbestimmung, mit einer SAR-Topologie nach dem Oberbegriff des Anspruchs 1 oder ein Verfahren zu Bestimmung von Werten nach dem Oberbegriff des Anspruchs 9. Insbesondere basiert die Erfindung auf einem CMOS-Prozess und einer SAR-Basistechnologie.

Neben dem Trend zu steigenden Verarbeitungsgeschwindigkeiten in der analogen Signalverarbeitung bestehen parallel meist Anforderungen an immer höhere Genauigkeit der Messungen. Flexibilität ist gefragt in Sachen Auflösung, Geschwindigkeit und Skalierbarkeit des Systems bei monolithisch integrierten Analog/Digital Wandlern.

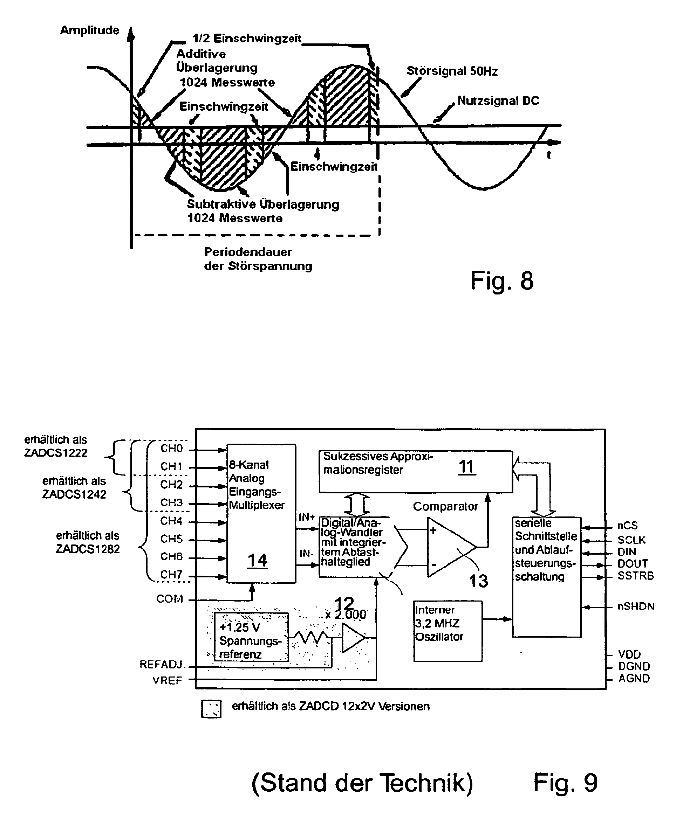

Für die Grundfunktion der Sukzessiven Approximation der SAR-Analog/Digital-Wandler ist kennzeichnend die Annäherung eines Vergleichswertes an den analogen Ausgangswert. Einfache sukzessive Approximation setzt dabei pro Schritt ein binäres Bit um. Ein vielfach genaueres und schnelleres Umsetzen kann erreicht werden, indem die Umsetzung redundant erfolgt, also pro Schritt nur ein Teil eines Bits umgesetzt wird. Ein ADU (Analog/Digital Umsetzer /Wandler) oder ADC (Analog Digital Converter), der nach dem Verfahren der sukzessiven Approximation (d.h. schrittweisen Annäherung) arbeitet, grenzt das eingehende Signal mittels Intervallschachtelung ein. Dazu besitzt er, wie in Fig. 9 dargestellt, im einfachsten Fall ein Datenregister (successive approximation register, SAR) 11, in dem zum Schluss der ermittelte digitale Wert steht, einen Digital-Analog-Umsetzer 12, der eine dem momentanen Digitalwert des Datenregisters entsprechende analoge Referenzspannung erzeugt, einen Komparator 13, der die erzeugte Referenzspannung mit dem Eingangsspannungssignal vergleicht, und ein Steuerwerk (Microcontroller 10). Für jedes Bit an Genauigkeit benötigt ein einfacher ADU jeweils einen Taktzyklus Umsetzungszeit. Fig. 9 zeigt einen derartigen SAR-Analog/Digital-Wandler mit Eingangs-Multiplexer der Fa. ZMD nach dem Stand der Technik. Derartige Umsetzer erreichen Auflösungen von ca.16 Bit bei einer Umsetzungsrate von ca. 1 MHz.

Die US 6,927,717B1 zeigt einen Chopper-basierenden Delta Sigma Analog/Digital-Wandler mit integrierender Funktion und Gruppenlaufzeit (Latenzzeit, Totzeitglied) über die beiden Dezimierer und das digitale FIR-Filter. Das Signal durchläuft generell über mehrere Stufen 52, 54, 56, 58 das FIR-Filter und die zwei Dezimierer. Das System beschreibt ein Messsystem für die Gleichspannungsmesstechnik (DC-Messung). Das System ist nicht echtzeitfähig in digitalen Regelkreisen.

McCartney, D et al: A Low-Noise Low-Drift Transducer ADC in: IEEE Journal of Solid State Circuits Vol. 32 Nr. 7, July 1997, S. 959 - 967 beschreibt eine Signalkette für die langsame nicht echtzeitfähige Anlog/Digital Wandlung basierend auf einem Delta/Sigma-Prinzip.

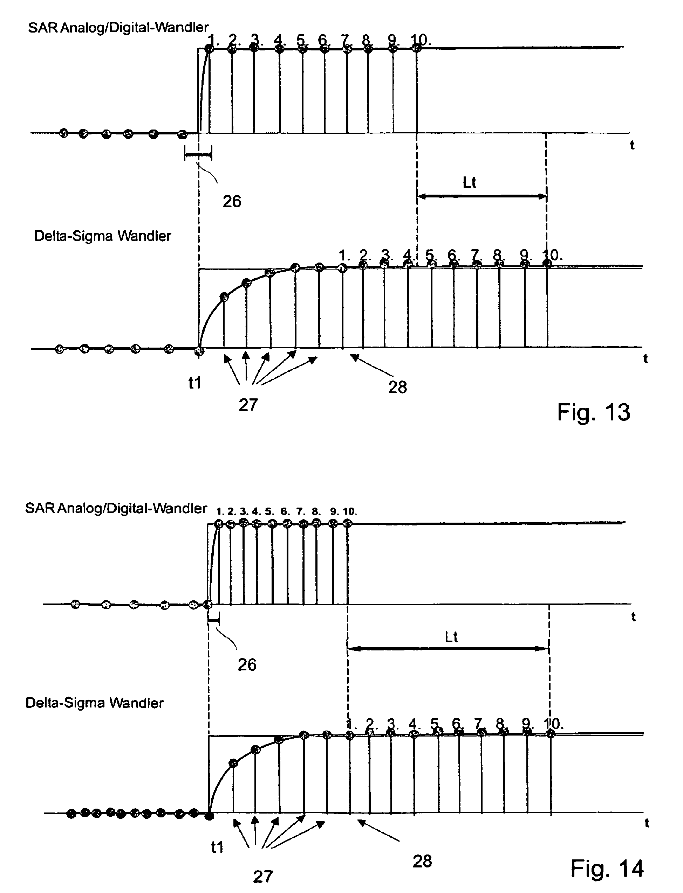

Die Patentanmeldung US 2007/0252747 As beschreibt ein System mit einem mehrstufigen Sinc Filter mit einer Dither-Funktion, die in dieser beschriebenen Konfiguration nicht echtzeitfähig ist. Ein SAR A/D-Wandler ist vorgesehen, aber mit dem Ziel Missing Codes bei der Wandlung zu vermeiden. Durch das vierstufige digitale Filter ist das System nicht echtzeitfähig. In Fig. 14a wird eine Signalkette mit vier hintereinander geschalteten Sinc-Filter beschrieben. Dadurch eignet sich das Verfahren nur für DC-Messtechnik. Ziel ist, die differenzielle Nichtlinearität (Abweichung der idealen Treppenstufe des Quantisierers) durch eine höhere nutzbare Auflösung des A/D-Wandlers über mehrere digitale Filter zu verbessern.

US-Patent US 7,049,989 B2 beschreibt eine einfache PGA-Funktion mit differenzieller Topologie durch Parallel- und Reihenschaltung von verstärkungsbestimmenden Widerständen die über ein digitales Potentiometer (DAC) und Analogschaltern realisiert wurde. Ziel ist dort, den Dynamikbereich (Aussteuerungsbereich) eines nachfolgenden Analog/Digital-Wandlers optimal zu nutzen und über den digital einstellbaren (programmierbaren) Verstärker anzupassen. Es handelt sich hierbei um bekannte angewandte Messtechnik, die aber in der Praxis aufgrund der Verwendung hochgenauer Widerstände kaum Anwendung findet. Den aktuellen Stand der Technik zeigt der Fachbeitrag Andreas Mangler, "Temperaturen präzise messen" in Wekaverlag Elektronik Distribution, Sonderheft Juni 2009, S. 16-21.

Aus YAZICIOGLU R F ET AL: "A 200 μW Eight-Channel Acquisition ASIC for AMBULATORY EEG Systems" 3. Februar 2008 (2008-02-03), SOLID-STATE CIRCUITS CONFERENCE, 2008. ISSCC 2008. DIGEST OF TECHNICAL PAPERS. IEEE INTERNATIONAL, IEEE, PISCATAWAY, NJ, USA, PAGE(S) 164-603, XP031440499 ISBN: 9781424450100ist ein AC-gekoppelter, chopper-stabilisierter Instrumentierungsverstärker (ACCIA) kombiniert mit einem nachfolgende weitem Hochpass-Filterstufe bekannt. Die Lösung ist damit auf den dort vorgesehen Einsatzzweck der Erfassung der Messwerte von Elektroenzephalogrammen abgestimmt, durch die AC-Kopplung werden jedoch die für eine Absolutwertmessung erforderlichen Gleichspannungssignale gelöscht, so dass eine Gleichspannungssignalkopplung für die präzise DC-Messung nicht möglich ist.

Die US 6,448,912 B1 offenbart bei einem aktiven Pixelsensor eine Mittelwertbildung mit Hilfe einer Überabtastung und eines Dithersignals. Gleichtaktsignale oder Gleichtaktstörungen werden mit dieser Methode nicht unterdrückt, sondern werden zum Wandlungsergebnis hinzu addiert. Da derartige Photosensoren kapazitiv (AC-Kopplung) an den nachfolgenden Analog/Digital Wandler gekoppelt werden, ist eine präzise Gleichspannungsmessung nicht möglich. Ein Korrelationsmeßverfahren zur Störsignalunterdrückung fehlt.

Aus Analog Devices: "CMOS, +1.8 V to +5.5 V / ±2.5 V, 2.5 Ohm Low-voltage, 8-/16-Channel Multiplexers ADG706/ADG707" 31. Mai 2002 (2002-05-31), XP002556474 Gefunden im Internet URL: http://www.analog.com/static/imported-files/Data_Sheets/ADG706_7007.pdf [gefunden am 2009-11-20] ist der allgemeine diskrete Aufbau von Multiplexern bekannt. Das Datenblatt beschreibt zwei unterschiedliche Konfigurationen von Multiplexern, nämlich einen 16zu1 Multiplexer und einen differenziellen 8zu1 Multiplexer.

Die in diesen Schriften offenbarten Delta Sigma Analog/Digital Wandler haben primär eine integrierende Funktion, somit das Verhalten eines niederfrequenten Tiefpasses mit einer definierten Einschwingzeit. Alle diese Verfahren sind in der beschriebenen Form für DC-Messung geeignet oder eingeschränkt in der langsamen AC-Messtechnik. Der nachfolgende Noise-Shaper und das digitale Filter erzeugen zusätzlich eine sogenannte Latenzzeit oder Gruppenlaufzeit. In der Regelungstechnik ist die resultierende Funktion des Delta Sigma Analog/Digital-Wandlers eine Kombination aus Tiefpass und Totzeit. Schnelle komplexe Echtzeitregelsysteme können deshalb nicht mit Delta Sigma Analog/Digital Wandlern realisiert werden. Hat man verschiedene überlagerte Regelkreise wie in Motorsteuerungen oder Mehrachsensystemen üblich wird das digitale Regelsystem instabil.

Eigenschaften der Delta Sigma Analog/Digital-Wandler sind:

- Limitiertes Sprungverhalten, Tiefpassfunktion
- arbeitet nur effizient mit kontinuierlichen Signalen am Eingang
- Latenzzeit /Gruppenlaufzeit des Systems führen zu Totzeiten in einem geschlossenen Regelkreis oder zu verzögerten Reaktionen bei einer Steuerung
- Taktrate hat direkten Einfluss auf die Übertragungsfunktion des digitalen Filters

Weitere Analog/Digital Wandler-Topologien sind

- Stufenweise Umsetzer (Zählverfahren)
- Single-Slope-Umsetzer (Sägezahn-/EinrampenverFahren/Zählverfahren)
- Dual-, Quad- und Multislope-Umsetzer (Mehrrampenverfahren)
- Delta-Sigma-Verfahren (Charge-Balance-Verfahren, 1-Bit-Umsetzer)
- Tracking-Umsetzer
- Wägeverfahren
- Redundante Umsetzer
- Flash-Umsetzer (Parallel-Umsetzer)
- Pipeline-Umsetzer
- Hybrid-Umsetzer

Jede dieser bekannten Wandlertopologien hat unterschiedliche Vor- und Nachteile. Die Wahl des Verfahrens in der Praxis ist ganz entscheidend vom Anwendungsfall abhängig. Universell einsetzbare Lösungen und gleichzeitig wirtschaftlich sinnvolle Lösungen gibt es nur wenige. Kommen ganz konkrete technische Anforderungen an Topologie und Funktion des Analog/Digital-Umsetzers hinzu, ist dies generell immer mit Kompromissen verbunden. Der Anwender muss sich dann bei verschiedenen Spezifikationen mit schlechten oder nicht ausreichenden Parametern zufrieden geben.

Folgende Parameter der Analog/Digital Wandler sind hierfür entscheidend:

- Signal-Rausch-Verhältnis
- Total Harmonic Distortion (THD) - Klirrverzerrungen
- Spurious Free Dynamic Range (SFDR) - Nutzbarer Dynamikbereich
- Effektive Anzahl von Bits (ENOB)
- Latenzzeit
- Monotonie
- Integrierende Funktion / Tiefpass-Verhalten
- Gleichtaktunterdrückung
- Differenzielle Linearität
- Integrale Linearität
- Kalibriertähigkeit
- Digitale Filterfunktionen

Ausgehend von diesem Stand der Technik liegt der vorliegenden Erfindung die Aufgabe zu Grunde, einen echtzeitfähigen universell einsetzbaren Analog/Digital-Wandler zu schaffen, der von verschiedenen Umsetzungs- oder Wandlungsverfahren die positiven Eigenschaften in einem Baustein kombiniert.

Diese Aufgabe wird mit einem Analog/Digital-Wandler mit den Merkmalen des Anspruches 1 oder durch ein Verfahren mit den Merkmalen des Anspruches 9 gelöst.

Durch eine Kombination eines differentiellen Eingangsfilters mit einer SAR-Topolo-gie, einer Chopper-Stufe und einer Synchronabtastung wird ein universell einsetzbaren Analog/Digital Wandler mit deutlich weniger Kompromissen geschaffen. Damit kann ein und derselbe Wandler für unterschiedliche Anwendungen und Applikationen eingesetzt werden. Die Topologie verwendet einen preiswerten CMOS-Prozess. Höhere Stückzahlen und Bündelung von Einkaufsvolumina sowie eine Bereinigung der Diversifizierung am Markt sind möglich. Damit ist eine effiziente, universelle als auch zugleich spezifische Analog/Digital-Umsetzung mit einem guten Preis/Leistungsverhältnis möglich. Schaltungstechnologie und Topologie im richtigen Zusammenspiel vermeiden mögliche Messfehler und daraus resultierende Probleme in der gesamten analogen Signalverarbeitungskette.

Das analoge Eingangsspannungssignal wird zuerst über den differenziellen Eingang des Multiplexers unmittelbar zum Microcontroller geführt. In der Praxis wird dazu das Eingangsfilter überbrückt. Diese erste schnelle Messung und Analog/Digital-Wandlung des Signals arbeitet nach dem SAR-Wandlungsprinzip. Für die Echtzeitfähigkeit in digitalen Regelkreisen ist dies die schnelle und direkte Durchleitung dieses Signals zum Prozessor. Damit ist eine schnelle Einzelmessung in Echtzeit mit maximaler Abtastrate des SAR-Wandlers möglich. Die zweite und alle folgenden Messungen werden über das Eingangsfilter und die Chopper-Stufe geführt. Somit kann der Anwender gemäß den Anforderungen sehr schnell mit 12 Bit Genauigkeit die erste Messung starten und verarbeiten und nach beispielsweise 20ms (Zeit für die Mittelwertbildung) ein 16 Bit bis 20Bit Mittelwertergebnis am Microcontroller abholen. Damit wird die Kombination aus schneller Wechselspannungsmesstechnik (AC-Messung) und genauer Gleichspannungsmesstechnik (DC-Messung) ermöglicht.

Weitere Vorteile ergeben sich aus den Unteransprüchen und der nachfolgenden Beschreibung eines Ausführungsbeispiels.

Im Folgenden wird die Erfindung an Hand eines in den beigefügten Figuren dargestellten Ausführungsbeispieles näher erläutert. Es zeigen:

Fig. 1     ein Blockschaltbild einer Chopper-Stufe in der Gesamttopologie eines SAR-Wandlers,

Fig. 2     die Choppertopologie eines Analog/Digitalwandlers im Detail mit Gleichtaktfilter,

Fig. 3     die Struktur des Gleichtaktfilters,

Fig. 4     eine äquivalente Eingangsstruktur eines Standard-Multiplexer mit Ersatzschaltbild der Eingangskapazitäten und des Sample/Hold-Kondensators,

Fig. 5     eine sin x/x-Funktion der Mittelwertbildung,

Fig. 6     eine Betrachtung der Mittelwertbildung im Zeitbereich,

Fig. 7     eine normierte Betrachtung im Frequenzbereich,

Fig. 8     Zusammenhänge zwischen einer Störfrequenz von z. B. 50Hz und einem Nutzsignal,

Fig. 9     einen SAR-Analog/Digitalwandler mit Eingangsmultiplexern nach dem Stand der Technik,

Fig. 10    die Rechenfunktionen des Microcontroller mit zuschaltbarer Dither-Funktion,

Fig. 11    das SAR-Prinzip im Vergleich zum Delta-Sigma-Prinzip,

Fig. 12    das Einschwingzeitverhalten der SAR-Topologie im Vergleich zur Delta-Sigma-Topologie ohne Berücksichtigung des digitalen Filters,

Fig. 13    das Zeitverhalten der SAR-Topologie im Vergleich zu Delta-Sigma-Topologie mit Berücksichtigung einer identischen Wandlungsrate mit der Verarbeitung von zehn Wandlungsergebnissen im digitalen Filter,

Fig. 14    das Zeitverhalten der SAR-Topologie im Vergleich zu Delta-Sigma-Topologie mit Berücksichtigung der schnellen Chopper-basierenden SAR-Topologie und der Verarbeitung von zehn Wandlungsergebnissen im digitalen Filter,

Fig. 15    die Choppertopologie eines Analog/Digital-Wandlers im Detail und mit Gleichtaktfilter und der direkten schnellen Leitungsführung über Schalterstellung 3 des Multiplexer und der Chopperstufe.

Beschreibung bevorzugter Ausführungsbeispiele

Analyse der Signalkette und externer Störeinflüsse auf eine analoge Messdatenerfassung

Während in der reinen Digitaltechnik Störsignale von mehreren 100mV noch kein Problem darstellen, dürfen die Störsignale auf der Analogseite sich hingegen nur im $\mu$V Bereich bewegen. Bei einem Eingangsspannungssignal von z. B. +/-1V und einer Auflösung von 16bit beträgt der Spannungswert von 1 LSB 2 V/$2^{16}$ = 30,5$\mu$V. Damit die volle Auflösung noch gewährleistet ist, müssten sämtliche Störungen auf 0,5 LSB begrenzt werden. Das entspricht in diesem Beispiel 15,25$\mu$V. Bei einer effektiven Auflösung von 12 Bit sind dies immerhin noch 488$\mu$V.

Diese Forderung ist in der Praxis nur sehr schwer erfüllbar, da digitale als auch analoge Komponenten der Datenerfassung massive Störquellen darstellen. Auf der digitalen Seite werden dieser Störquellen verursacht z.B. durch:

- Hochfrequentes Takten von Prozessoren

- Externe Speicher

- Programmierbare Logik

- Oszillatoren

- Hochfrequente Störanteile auf Bussignalen von PC oder anderen externen Steuerungen

- Brummspannungen der Spannungsversorgung

Die Störquellen auf der Analogseite sind:

- Rauschen des Sensors
- Rauschen des A/D-Wandlers
- Umschaltvorgänge externer Multiplexer
- Umschaltvorgänge programmierbarer Verstärker, falls diese vor dem A/D-Wandlers eingesetzt werden
- Hochfrequente Störspitzen auf der Versorgungsspannung, hervorgerufen durch verwendete Schalt-Regler

Von allen Funktionsblöcken der Signalkette können sowohl Störungen ausgehen als auch Störungen in das System eingekoppelt werden (Störquelle, Störsenke), die dann die Funktion des Analog /Digital-Wandlers negativ beeinflussen

Unterdrückung von Störeinflüssen durch ein differenzielles Eingangsfilter

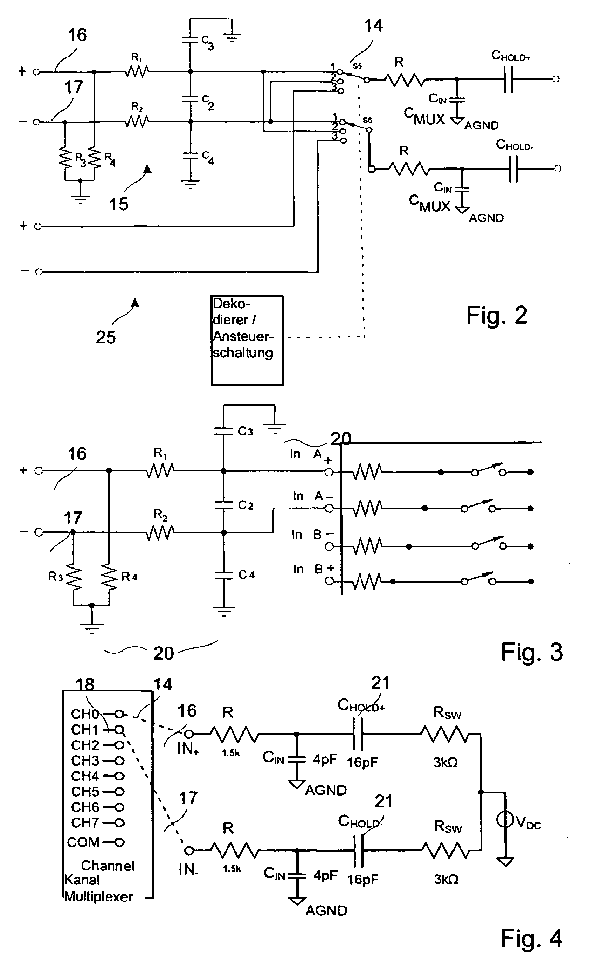

Zur Beseitigung derartiger Störungen ist erfindungsgemäß zunächst ein differenzielles Eingangsfilter vorgesehen. Das zu messende Signal wird gemäß Fig. 2,4 über die Anschlüsse 16 und 17 geführt. Bei der Differenzmessung werden diese Anschlüsse für jede Signalquelle als Signalleitung 16 und Signalbezugsleitung 17 ausgebildet und über einen differenziellen Multiplexerkanal 18 geführt. Die Gleichtaktspannung an den differenziellen Eingängen des ADC's bezieht sich auf die relativ unkritische Masseleitung. Dadurch können die Ausgleichströme zwischen dem Datenerfassungssystem und den Signalquellen nur über diese unkritische Masseleitung fließen. Eine gegenseitige Beeinflussung der Signalkanäle wird somit wirksam unterdrückt. Mit dieser "echten" differenziellen Eingangsstruktur des ADC's ist es möglich, durch das gleichzeitige (simultane) Sampling des Plus-Eingangs (+) und des Minus-Eingangs ( - ) sehr effizient Gleichtaktstörungen zu unterdrücken.

Beschreibung der Eingangsfilterstruktur

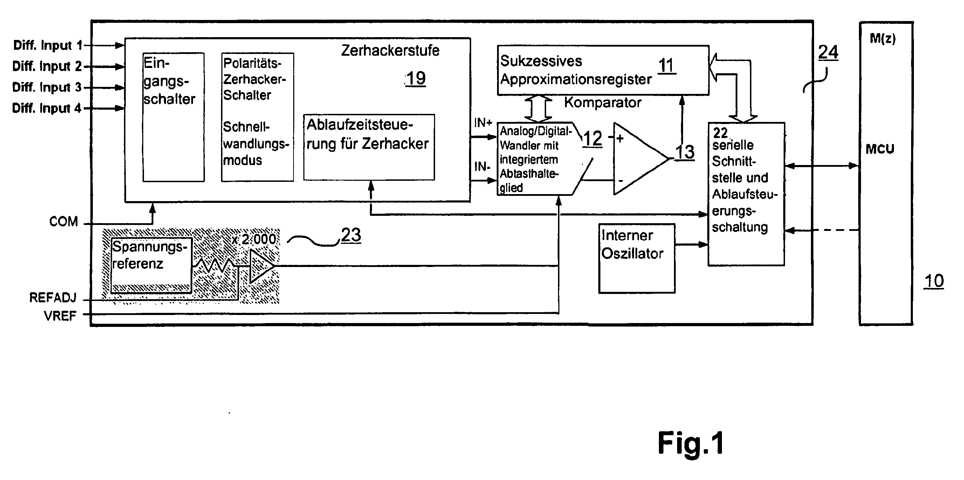

Fig. 3 zeigt die Struktur des Eingangsfilters. Die Widerstände R1, R2, R3, R4 bilden zusammen mit den Kondensatoren C2, C3, C4 ein Eingangsfilter 15, das der Chopperstufe 19 gemäß Fig. 1 vorgeschaltet ist. Das Eingangsspannungssignal gelangt über einen passiven Tiefpass an einen der differenziellen Eingänge des internen Multiplexers 14. Durch das Filter werden sowohl die hochfrequenten Störanteile als auch die eingekoppelten Gleichtaktstörungen, die dem Nutzsignal überlagert sind, unterdrückt und das am Multiplexer anstehende Signal ist somit rauschärmer.

Der Berechnung der Eingangswiderstände für den Biasstrom des Multiplexers liegt folgende Überlegung zu Grunde. Ein hochohmiger, offener differenzieller Eingang hat keinerlei Bezug zur Masse und würde unweigerlich undefiniert driften. Abhilfe schafft das sogenannte "Biasing". Das sind hochohmige Widerstände von beiden Eingängen zur Masse 20 (z. B. Kanal 1 R3, R4). Bei Eingangstufen mit einem definierten typischen Differenz-Biasstrom des Multiplexers verursacht dieser Strom an den Bias-Widerständen eine Differenzspannung. Deshalb muss die Größe der Widerstände so gewählt werden, dass die Differenzspannung kleiner ist als die gewünschte Messgenauigkeit des Systems. Um diese Spannung z. B. auf maximal 500μV zu begrenzen, darf der Widerstandswert von R3 und R4 höchstens 500μV/Differenz-biasstrom betragen. Typischerweise werden diese Widerstände mit 1MΩ bestückt. In diesem Zusammenhang ist die Differenzspannung eine Spannung an massebezogenen oder differenziellen Eingängen, die nicht Bestandteil des Eingangsspannungssignal ist. Man spricht auch von einer Fehlerspannung.

Bei Einsatz z.B. von niederohmigen Brückenschaltungen können die Widerstände R3 und R4 entfallen, da in diesem Fall der Biasstrom über die niederohmigen Brückenwiderstände fließt. Sollte jedoch eine Spannungsquelle an den Eingangsteil angeschlossen werden, die keinen Massebezug zu der Platine hat, muss mindestens einer dieser beiden Widerstände bestückt werden. Ob beide Widerstände zu verwenden sind, hängt vom Innenwiderstand der zu messenden Quelle ab. Ist dieser klein, kann z. B. auf R3 verzichtet werden. Die Eingangsströme fließen in diesem Fall direkt über R4 gegen Masse und im anderen Fall zuerst durch die Quelle und dann über R4 gegen Masse. Zum besseren Verständnis der internen Eingangstopologie des ADC's zeigt Fig. 4 das äquivalente Ersatzschaltbild mit der Eingangskapazität während eines Sampling-Vorgangs.

Die beiden Widerstände R1 und R2 bilden zusammen mit dem Kondensator C2 einen Tiefpass für die Eingangssignalspannung, wobei sich die Grenzfrequenz nach folgender Formel berechnen lässt.

$$f_{3dB} = \frac{1}{2 \cdot \pi \cdot (R_1 + R_2) \cdot (C_2 + \frac{C_{3,4}}{2})}$$

$$f_{3dB} = \frac{1}{2 \cdot \pi \cdot (309\Omega + 309\Omega) \cdot (1\mu F + \frac{47nF}{2})} = 252Hz$$

Das Filter wurde im Ausführungsbeispiel für eine Grenzfrequenz von 252Hz dimensioniert. Gemäß obiger Formel kann damit eine Frequenz von ca. 1 Hz noch mit einer Genauigkeit von 16-Bit (bezogen auf eine normierte Eingangsspannung von ±2,5V) erfasst werden.

Die Grenzfrequenz kann nach der Formel

$$f_g = \frac{f_{Bit}}{\sqrt{\left(\frac{2^{n+1}}{2^{n+1}-1}\right)^2 - 1}}$$

berechnet werden. Dabei ist

$f_{Bit}$ = Grenzfrequenz, bei der noch eine der Genauigkeit entsprechende Auflösung gewährleistet,

n = Auflösung in Bit,

$f_g$ = 3dB Grenzfrequenz vom passiven RC-Tiefpass.

Mit den für diese Schaltung verwendeten Werten ergibt sich eine Grenzfrequenz von:

$$f_g = \frac{1Hz}{\sqrt{\left(\frac{2^{16+1}}{2^{16+1}-1}\right)^2 - 1}} = 256Hz$$

Die Kondensatoren C3, C4 des Eingangsfilters 15 bilden mit den Widerständen R1, R2 ein symmetrisches HF-Filter für hochfrequente Gleichtaktsignale. Die Grenzfrequenz der gewählten Filteranordnung liegt bei 10,9kHz. Beide Eingänge des ADC's sollten symmetrisch abgeschlossen sein. Dadurch lassen sich Signale auch im mV Bereich noch mit hoher Genauigkeit erfassen.

Die Gleichtaktunterdrückung des ADC nimmt mit steigender Frequenz der Gleichtaktsignale ab. Deshalb dürfen nur niederfrequente Gleichtaktstörungen am ADC anliegen. Der ADC hat bei für niederfrequente Gleichtaktsignale (bis 50Hz/60Hz) eine Unterdrückung von typisch 100dB, bezogen auf die $V_{Ref}$. Durch das symmetrische HF-Filter werden bereits die höherfrequenten Gleichtaktsignale schon am Eingang des ADC mit 20dB/dekade unterdrückt. Somit bleibt die Gleichtaktunterdrückung des gesamten Systems immer über 75dB.

Höhere Werte können gewonnen werden, wenn die Grenzfrequenz des HF-Filters weiter herabgesetzt wird. Dabei dürfen jedoch nur die Werte der Kondensatoren C3 und C4 vergrö-βert werden, da sich bei einer Veränderung der Widerstände R1 und R2 auch die Grenzfrequenz des Signal-Tiefpasses verändern würde. Es ist jedoch zu beachten, dass sowohl die Kondensatoren als auch die Widerstände bestimmten Toleranzen unterliegen. Bei den Kondensatoren ist es aus wirtschaftlichen Gründen kaum realisierbar, Toleranzen unter 1% einzusetzen. Durch diese Toleranzen ergeben sich bereits abweichende Grenzfrequenzen für die beiden differenziellen Eingänge. Das hat zur Folge, dass das anliegende Gleichtaktsignal unterschiedliche Spannungspegel an den Kondensatoren C3 und C4 erzeugt. Die dadurch entstehende Differenzspannung erscheint, als Fehlerspannung am Ausgang des ADC.

Die größte Differenzspannung entsteht im Bereich der Grenzfrequenz des symmetrischen HF-Filters (10,9kHz). Diese Spannung wird jedoch durch den Kondensator C2 kurzgeschlossen, der parallel zu der erzeugten Differenzspannungsquelle liegt. Deshalb sollte C2 sehr viel größer als C3 und C4 sein. Im Ausführungsbeispiel wurde C2 um den Faktor 20 größer gewählt als C3 und C4. Die Differenzspannung am Multiplexereingang hängt bei einer Unsymmetrie des HF-Filters sehr stark von dem Kondensator C1 ab.

Es könnten prinzipiell auch Kondensatoren mit $\pm 10\%$ Toleranz verwendet werden, sofern die Möglichkeit einer Selektion besteht. Der Absolutwert der Bauteile ist hier relativ unkritisch, da die beiden Kondensatoren nicht auf einen absoluten Wert ausgemessen werden müssen. Das Matching ist entscheidend. Eine Hersteller-"char-genreine" Selektion der Bauelemente könnte unter Umständen ähnliche Ergebnisse liefern. Es genügt jedoch, wenn die Kapazitätswerte beider Bauteile gegeneinander eine relative Abweichung von $\pm 1\%$ haben. Sind die Kondensatoren alle aus einer Charge, so können oft Abweichungen der Kapazitäten von weniger als 1% erreicht werden, obwohl die absolute Abweichung der Kapazität gegenüber dem aufgedruckten Wert nach wie vor $\pm 10\%$ betragen kann. In der 16 Bit Messtechnik wird idealerweise eine chargenreine 1 % Selektion empfohlen.

Beeinflussung des Messergebnisses durch die parasitären Kapazitäten des Multiplexers beim Umschalten der einzelnen Kanäle.

Die Messergebnisse können zudem beim Umschalten der Multiplexerkanäle beeinträchtigt werden. Beim Umschalten der Eingangskanäle mit dem Multiplexer(MUX) 14 müssen die internen Kondensatoren (typ. 4pF) am Ausgang des Multiplexers auf die jeweils neue Eingangsspannung umgeladen werden. Die Umladezeit der parasitären Ausgangskondensatoren ist von den wirksamen Widerständen und der Größe des Spannungssprunges abhängig. Die längste Einschwingzeit ist demnach bei der Umschaltung zwischen einem Kanal, an dem -1,25V anliegt, und einem anderen Kanal, an dem +1,25V ansteht, zu erwarten. (Fig. 4)

Da die beiden Einschaltwiderstande ($R_{MUX}$=1,5kΩ) als auch die interne Ausgangskapazität des Multiplexers bekannt sind, kann die Einschwingzeit t nach der Formel

$$t = -R_{MUX} \cdot C_{MUX} \cdot \ln\left(\frac{u_2(t) - u_1(0)}{u_2(0) - u_1(0)}\right)$$

berechnet werden mit
$u_1(0)$ = Eingangsspannung des Multiplexers im Umschaltmoment,
$u_2(0)$ = Spannung am $C_{MUX}$ im Umschaltmoment,
$u2(t)$ = Spannung am Kondensator nach der Zeit t.

Mit den im Ausführungsbeispiel gewählten Werten
$R_{MUX}$ = 1,5k Ω,
$C_{MUX}$ = 4pF,
Spannungssprung von -1,25V nach +1,25V,
Genauigkeit = 16Bit bei 2,5V. $(2,5V/(2^{16}))=38,15\mu V$
ergibt sich die Einschwingzeit t zu:

$$t = -(2 \cdot 1{,}5 k\Omega) \cdot \frac{4pF}{2} \cdot \ln\left(\frac{1{,}24996185V - 1{,}25V}{-1{,}25V - 1{,}25V}\right) = 66{,}54 ns$$

Die Einschwingzeit wurde unter dem Gesichtspunkt berechnet, dass die Eingangsspannung des Multiplexers aus einer niederohmigen Spannungsquelle gespeist wird. Das ist jedoch durch die Widerstände R1 und R2, die für das Eingangsfilter verwendet werden müssen, nicht gewährleistet. Des Weiteren wird der Kondensator C2, der parallel zu den beiden in Reihe geschalteten Multiplexerkapazitäten CMUX liegt, entladen.

Deshalb sollte C2 bei einer gewünschten Genauigkeit von 16bit um den Faktor $2^{16}$ größer sein als die beiden in Reihe geschalteten Multiplexerkapazitäten CMUX. Die wirksame Multiplexerkapazität beträgt durch die Reihenschaltung 2pF (4pF/2). Folglich muss C2 > 0,13$\mu$F ($2^{16}$ *2pF) sein. Bei der im Ausführungsbeispiel verwendeten Eingangskapazität von 1$\mu$F ist das gewährleistet. Bei einer kleineren Kapazität als der im Beispiel geforderten 0,13$\mu$F muss für das Eingangsfilter zwischen dem Umschaltzeitpunkt des Multiplexers und dem Abtastzeitpunkt des A/D-Wandlers eine Verzögerungszeit vorgesehen werden, damit dem Filter zum Einschwingen genügend Zeit verbleibt.

In solch einem Fall ist z.B. ein Spannungssprung von -1,25V nach +1,25V bei einer verkleinerter Eingangskapazität C2 von 0,1 $\mu$F gegeben. An Kanal 1 liegt ein Pegel von -1,25V. Der Multiplexer 14 ist seit längerer Zeit mit diesem Kanal verbunden. Das System kann somit als eingeschwungen betrachtet werden. Die differenzielle Ausgangsspannung des Multiplexers ist daher ebenfalls -1,25V. Unter diesem Gesichtspunkt liegen die internen Ausgangskondensatoren in Reihe und es ergibt sich eine Gesamtkapazität von 2pF (4pF/2). An diesen 2pF liegt nun eine Spannung von -1,25V. Das entspricht einer Ladung von -1,25V · 2pF = - 2,5pC

Wird der Multiplexer auf Kanal 0 umgeschaltet, dessen Eingangsspannung sich auf +1,25V befindet, liegen im ersten Moment am Ausgang des Multiplexers immer noch -1,25V an. Der Kondensator C2 sowie die in Reihe geschalteten Kapazitäten C3 und C4 liegen jedoch auf +1,25V. Dies entspricht einer Ladung von 1,25V*(0.1$\mu$F+(47nF/2) = 154,37nC. Die Multiplexerkapazität entlädt also das Eingangsfilter auf den Spannungswert von

$$U_{tot} = \frac{(154nC - 2{,}5pC)}{(0{,}1\mu F + (47nF/2) + 4pF/2)} = 1{,}2498989787V$$

Das bedeutet eine Abweichung von: 1,25V- 1,249898787V=101,1$\mu$V.

Für eine Auflösung von 16-Bit bei einem Eingangsspannungsbereich von $\pm$1,25V darf die Abweichung jedoch nicht größer als 2,5V/$2^{16}$=38,15$\mu$V sein. Aus diesem Grund sollte nicht sofort nach dem Umschalten des Multiplexers die A/D-Wandlung gestartet werden. Nach der vorhergehenden Formel kann die Verzögerungszeit wie folgt berechnet werden:

$$t = -(2 \cdot 309\Omega) \cdot (0{,}1\mu F + 23{,}5nF + 2pF) \cdot \ln\left(\frac{1{,}24996185V - 1{,}25V}{1{,}249898787V - 1{,}25V}\right) = 74{,}47\mu s$$

Zwischen dem Umschalten des Multiplexers 14 und der darauffolgenden Messung durch den A/D-Wandler muss also in diesem Fall 74,47$\mu$s gewartet werden, damit das System auf eine Genauigkeit von 16-Bit eingeschwungen ist. Diese Verzögerungszeit ist jedoch nur gültig für Spannungsquellen mit einen Innenwiderstand R<< R1+R2. Für Quellen mit einem höheren Innenwiderstand muss dieser zu den Eingangswiderständen R1, R2 addiert werden. Daraus folgt, dass sich die Einschwingzeit des Systems zusätzlich erhöht. Abhilfe kann in diesem Falle nur ein Impedanzwandler (Buffer Amp) am Eingang des Tiefpasses oder ein größerer Eingangskondensator C2 > 0,39$\mu$F schaffen.

Zum Vergleich wird die Spannungsänderung unter geänderten Bedingungen aufgezeigt, wobei nun der Eingangskondensator C2 eine Kapazität von 1$\mu$F hat.

Ladung von C2, C3 und C4:

$$Q_2 = 1{,}25V \cdot (1\mu F + (47nF/2) = 1{,}2794\mu C$$

Ladung von $C_{MUX}$

$$Q_{MUX} = -2,5\,pC$$

.

Die Multiplexerkapazität entlädt das Eingangsfilter 15 auf den Spannungswert von

$$U_{tot} = \frac{(1,274\mu C - 2,5\,pC)}{(1\mu F + (47nF/2) + 4pF/2)} = 1,24999511V$$

Dies entspricht einer Abweichung von 1,25V - 1,2499951= 4,885µV. Somit ist die Abweichung vom Idealwert 2,5V größer als 38µV und man bewegt sich im Bereich der 16-Bit-Auflösung. Der A/D-Wandler kann sofort mit einer Wandlung beginnen.

Wo liegt nun die Grenze der maximalen Auflösung?
Unter folgender Annahme berechnet sich die maximal nutzbare Auflösung so:

Wählt man C2= 2,2µF
= > Q2= 2,7793µC
=> $U_{tot}$ = 1,24999775V
=> $U_{error}$= 2,2487µV
$U_{20BIT}$= 2,384µV
$U_{20BIT}$ entspricht der Fehlerspannung $U_{error}$
d.h. die Topologie erlaubt bei einem eingeschwungenen System eine effektive Auflösung von 20 Bit Genauigkeit bei C2= 2,2µF.

Diese Erkenntnis liefert die idealen Vorraussetzungen den Baustein in einer Chopper und Mittelwert bildenden Topologie einzusetzen.

Unter Einbeziehung der kompletten Signalkette ist die Quellimpedanz des Sensors oder der Signalquelle ganz entscheidend für die Umladung der Kapazitäten bis zum eingeschwungenen Zustand. Niederohmige Brückenschaltungen sind daher problemlos direkt an dem ADC zu betreiben. Quellimpedanzen die höher sind als 1kOhm erfordern dann unter Umständen eine Bufferstufe am Eingang.

Die Mittelwertbildung (Averaging)

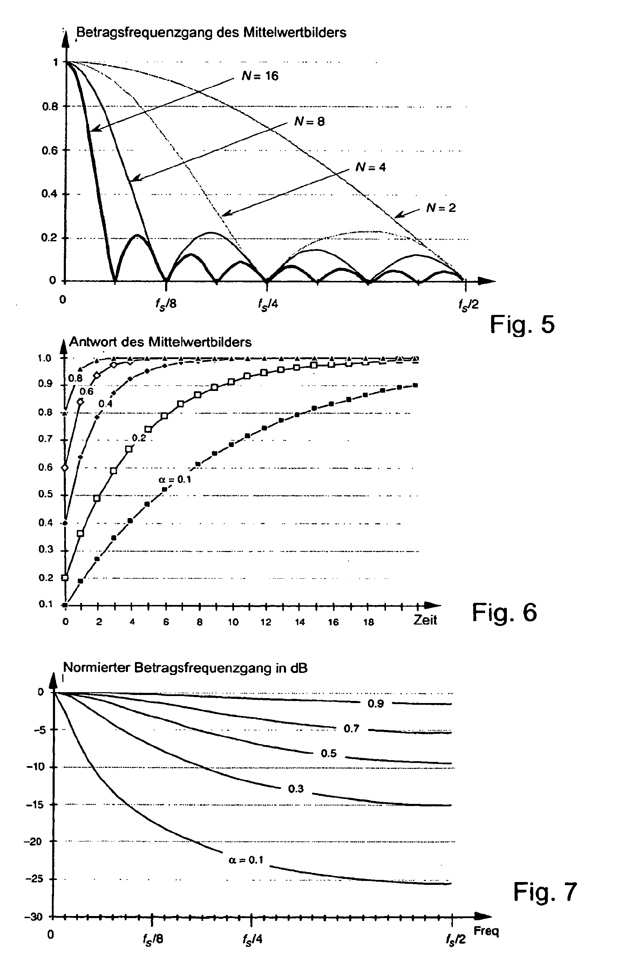

Eine Mittelwertbildung erhöht die Auflösung und führt zu zusätzlichen Zwischenwerten im Messergebnis. Der Grundgedanke beinhaltet einen A/D-Wandler, der mit sehr hoher Abtastfrequenz das Eingangsspannungssignal überabtastet (oversampling). Die Flut der dabei entstehenden Daten wird durch eine digitale Mittelwertbildung (Average) reduziert und somit für normale Controllergeschwindigkeiten verwertbar. Die Filterkurve zeigt Fig. 5.

Vorteile:

• Das Antialiasing-Filter ist einfach und preiswert aufzubauen, da die maximale Grenzfrequenz des Filters wesentlich kleiner ist als die halbe Ablastfrequenz des Wandlers sein kann.

• Hochfrequente Rauschanteile des Eingangsspannungssignals werden durch die Mittelwertbildung stark gedämpft.

• Gezielte Unterdrückung einer bestimmten Störfrequenz und ihrer harmonischen Oberwellen durch Anpassung des Mittelwert-Zeitfensters auf ein Vielfaches der Periodendauer des Störers.

• Durch Veränderung der Anzahl der zum Averaging benutzten Wandlungen können verschiedene Messzeiten realisiert werden.

Es sollten folgende Punkte beachtet werden:

• Verwendung eines schnellen A/D-Wandlers

- Die digitale Mittelwertbildung der Wandlerdaten benötigt eine schnelle Addition, für die nur schnelle Microcontroller in Frage kommen.

Die Mittelwertbildung (Averaging) hat die Aufgabe, die vom A/D-Wandler ausgegebenen 12-Bit-Worte auf ein 16-Bit-Wort oder gar 20 Bit-Wort umzusetzen. Dies wird mit Hilfe des Controllers 10 realisiert. Dafür wird eine bestimmte Anzahl von Messwerten eingelesen, aufsummiert und danach durch die Anzahl der Messwerte geteilt. Geht man bei einem A/D-Wandler davon aus, dass der Umsetzer bei einem konstanten Eingangsspannungssignal kein konstantes Bitmuster liefert, sondern eine Gauß'sche Verteilung der Codes, so kann durch eine Mittelwertbildung die Auflösung des Umsetzers erhöht werden. Dabei gilt allgemein: Σ(eingelesene Messwerte) / (Anzahl Messwerte)

Werden z. B. bei zwei aufeinanderfolgenden Messungen folgende Werte ermittelt: Messung 1 = 100mV, Messung 2 = 101mV

beträgt die Differenz 1mV. Werden nun beide Werte addiert und durch zwei geteilt, so erhält man eine Nachkommastelle. (100mV + 101 mV) / 2 = 100.5mV

Der Gewinn dieser "Nachkommastelle" repräsentiert somit eine erhöhte Auflösung.

Addition eines Dither-Signales zum digitalisierten Messwert

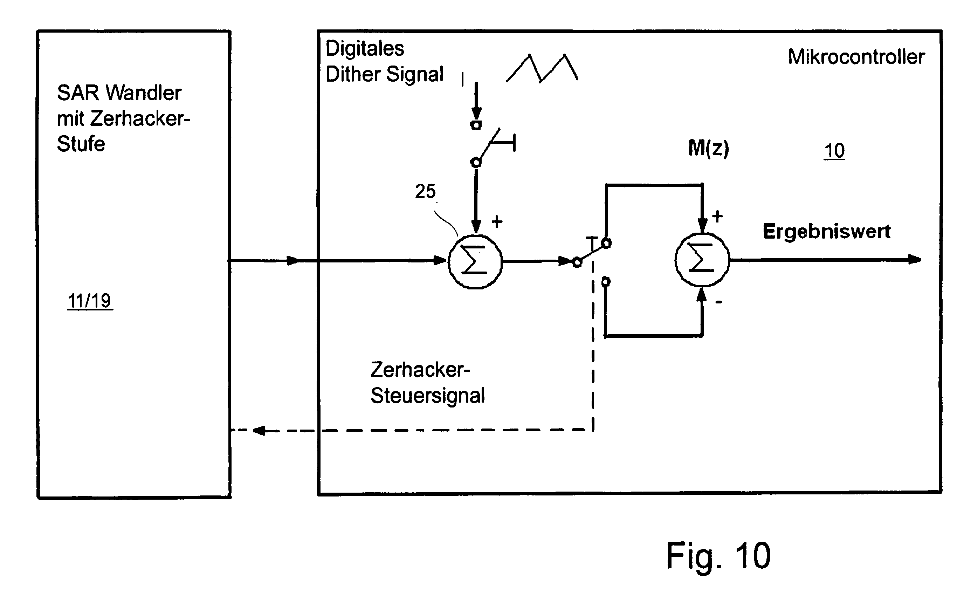

Wenn besonders kleine analoge Signal verarbeitet werden, besteht die Möglichkeit vor der Mittelwertbildung im Microcontoller dem digitalen Signal ein Dither-Signal zu überlagern bzw. zu addieren. Dies ist eine Option, die gemäß Fig. 10 zugeschaltet werden kann.

Das Prinzip der Dither-Technologie ist weitestgehend bekannt und populär in der digitalen Verarbeitung dynamischer Signale.

Dithering bezeichnet eine Technik, um zusätzliche Quantisierungsfehler, die bei der Umwandlung bereits quantisierter Datenfolgen in ein anderes quantisiertes Datenformat entstehen, zu minimieren. Dithering ist ein Verfahren aus dem Bereich der statistischen Signalverarbeitung.

Bei einer digitalen Formatkonvertierung, also der Umwandlung bereits digitaler Daten von einem digitalen Format in ein anderes, treten in Abhängigkeit vom digitalen Eingangsspannungssignal, und da besonders bei kleinen Signalpegeln, nichtlineare Verzerrungen auf. Weiter sind die Voraussetzungen für die Beschreibung dieses Fehlers als klassisches Quantisierungsrauschen, wie es bei der Umwandlung von analogen Signalen in digitale Signalfolgen auftritt, nicht mehr gegeben. Zur Reduzierung dieser nichtlinearen Effekte, vor allem bei kleinen Signalamplituden, ist daher eine Linearisierung der Kennlinie des Requantisierers notwendig. Dieses wird durch ein statistisches Verfahren erreicht, bei dem vor der Requantisierung zu dem digitalen Eingangssignal ein Zufallssignal, ein Rauschen, addiert wird. Dieses zusätzliche Rauschsignal wird als Dither-Signal bezeichnet und gibt diesem Verfahren seinen Namen.

Mit diesem Verfahren erreicht man mit entsprechend gewählten Dithersignal, im Mittel über eine längere Signalfolge, eine Verfeinerung der Abstufung bei der Requantisierung, womit die Übertragungskennlinie linearisiert und Störeffekte minimiert werden. Der Requantisierungsfehler äußert sich ähnlich einem Quantisierungsrauschen, einem breitbandigen Rauschen ähnlich dem Rauschen z. B. eines analogen Verstärkers - bei einem voll ausgesteuerten dynamischen Signal fällt dieses nicht sonderlich ins Gewicht, da die mögliche Dynamik ausgeschöpft wird und sich das Quantisierungsrauschen als breitbandiges "Weißes Rauschen" darstellt, das im Vergleich zum Maximalsignal sehr klein ist. Problematisch wird es allerdings, wenn das Signal nur einen Teil der Quantisierungsstufen nutzt - beispielsweise extrem kleine Signalpegel, die anstelle von z. B. 12 bis 16 Bit nur 1 bis 8 Bit verwenden. Hier wird der Signal/Rauschabstand umso geringer. Noch schlimmer ist allerdings die Korrelation des Quantisierungsfehlers - sie entsteht dadurch, dass Wellenkurven durch die Quantisierung in ein geringstufiges Quantisierungsmuster immer mehr einer Rechteckform ähneln.

Um besonders kleine Signale, die nun nicht mehr richtig dargestellt werden, von diesem Quantisierungsfehler zu lösen (zu dekorrelieren), wird dem Signal ein Dither-Rauschen hinzugegeben. Dadurch erhöht sich zwar die Rauschenergie im Signal, allerdings werden die sehr kleinen Signalanteile nun besser wahrgenommen als vorher. Das liegt daran, dass durch die Überlagerung mit Rauschen die Rechteckschwingung wieder eher als die ursprüngliche Wellenform wiedererkannt wird. Denn im Prinzip einer Pulsweitenmodulation wird das Wellensignal nun, umso näher es der jeweiligen Quantisierungsstufe steht, durch das Rauschen dekorelliert und wechselhafter den jeweiligen Quantisierungsstufen zugeordnet. Durch diese wechselhafte Zuordnung (daher "Dither" = "zittern") wird die Rechteckschwingung umgangen.

Über eine Berechnung des Mittelwertes wird damit eine Erhöhung der Auflösung erreicht. Anders ausgedrückt: In einem 1-Bit-System (0 und 1) wird eine Sinuswelle den Quantisierungsstufen beispielsweise folgendermaßen zugeordnet: 000011110000111100001111. Hieraus resultiert eine Rechteck-Schwingung. Durch Hinzugabe von Dither-Rauschen entsteht eine genauere Nachbildung der Sinus-Form: etwa 001100110011001100110011. Die negativen Verzerrungseffekte der Rechteck-Schwingung treten nicht mehr auf, das ursprüngliche Signal wird klarer erkannt. Es können so sogar Signale dargestellt werden, die kleiner als das kleinste Quantisierungsintervall sind!

Das Dither-Rauschen entspricht in etwa Weißem Rauschen, jedoch mit dem Unterschied, dass es statistisch anders verteilt ist. Verschiedene Dither-Typen werden aufgrund der Wahrscheinlichkeitsdichte-Funktion ihrer Amplitudenverteilung unterschieden - am bekanntesten sind dreiecksförmig verteilter Dither (Triangular Probability Density Function - Dither, TPDF-Dither), rechteckförmig verteilter Dither (RPDF-Dither) und Gaussisch verteilter Dither (Gaußian Probability Density Function-Dither).

Ein ungedithertes Digitalsignal kann einem Analogsignal in Bezug auf den Rauschabstand unterlegen sein - ein korrekt gedithertes Digitalsignal hingegen ist einem analogen System in Bezug auf den Rauschabstand überlegen. Die Dither-Technologie findet auch in der digitalen Signalverarbeitung ihre Anwendung, wo Daten des internen Datenbusses von Prozessoren (Microcontrollern) auf die Breite des externen Datenbusses reduziert werden. Anstatt die "überflüssigen" Bits einfach abzuschneiden ("Truncation"), wenn z. B. ein 32 Bit - Signal (Busbreite des Microcontrollers) in ein 20 Bit-Signal gewandelt wird, sollte Dither hinzugefügt werden, da sonst die oben beschriebene Problematik des Quantisierungsfehlers wieder auftritt. Geräte in der dynamischen Signalverarbeitung arbeiten auch intern mit Dither, da durch Gleitkomma-Berechnung innerhalb des Microcontrollers weitere Quantisierungsfehler auftreten.

Theoretische Betrachtung der Mittelwertbildung und "Chopper-Technik"

Der zeitliche Mittelwert eines Analogsignals berechnet sich als:

$$m(t) = \frac{1}{T_m} \int_{t-Tm}^{t} u(t)dt$$

Das Spektrum des analogen, zeitkontinuierlichen Mittelwerts entspricht dem des bekannten Kammfilter (sin x) / x -Funktion (Fig. 5):

$$\left|\frac{M(f)}{U(f)}\right| = \left|\frac{\sin(\pi \cdot T_m \cdot f)}{\pi \cdot T_m \cdot f}\right|$$

$T_m$ = Zeitfenster der Mittelwertbildung

Bei einer Betrachtung im Zeitbereich ergibt sich ein Bild gemäß Fig. 6 und eine normierte Betrachtung im Frequenzbereich zeigt Fig. 7.

Damit werden die Frequenz $1/T_m$ und ihre harmonischen Oberwellen völlig ausgelöscht. Die Maxima fallen mit 20dB/Dekade ab. Im Microcontroller 10 wird der Mittelwert aus N-Abtastwerten berechnet, die vom A/D-Wandler in äquidistanten Zeitabständen T erzeugt werden. Das Spektrum des zeitdiskreten Mittelwertes aus N-Abtastwerten berechnet sich mit Hilfe der Z-Transformation zu:

$$M(z) = X(z) \cdot \left[1 + z^{-1} + ..... + z^{-(n-1)}\right]$$

$$\frac{M(z)}{\chi(z)} = \frac{1}{N} \sum_{x=0}^{N-1} z^{-1} = \frac{1}{N} \cdot \frac{1-z^{-N}}{1-z^{-1}}$$

$$z = e^{-j\omega T}$$

$$\left|\frac{M(f)}{U(f)}\right| = \left|\frac{\sin(N \cdot \pi \cdot f \cdot T)}{\pi \cdot T_m \cdot f}\right|$$

Das Spektrum des zeitdiskreten Mittelwertes zeigt auch die beschriebene KammfilterÄhnlichkeit, jedoch nehmen oberhalb der halben Abtastfrequenz 1/2T die Maxima wieder zu. Dies resultiert aus der Verletzung des Shannon-Abtasttheorems. Es besagt, dass die maximale Frequenz am Analogeingang des A/D-Wandlers kleiner als die halbe Abtastfrequenz sein muss.

Die Einhaltung des Shannon-Theorems kann bei überabtastenden Systemen relativ einfach durch ein einpoliges Filter erreicht werden. Der errechnete, zeitdiskrete Mittelwert ist der "gleitende Mittelwert" d. h. der Ergebnis-Sample-Strom M(z) hat die gleiche Datenrate wie der ADC-Sample-Strom X(z). Das entspricht einem FIR-Filter mit N-Taps, dessen N-Koeffizienten gleich 1 sind. Es müssen immer die letzten N-Abtastwerte zwischengespeichert werden. Hierzu ist ein hoch performanter Microcontroller oder ein FPGA (Field Programable Gate Array)oder PLD (Programable Logic Device) notwendig.

Im Microcontroller wird aus N-Abtastwerten ein Mittelwert gebildet und danach ein Mittelwert aus den nächst folgenden N-Abtastwerten. Der Ergebnis-Sample-Strom ist dann um das N-fache niedriger als der ADC-Sample-Strom. Dieser "Block-Mittelwert" über N-Abtastwerte entspricht einem gleitenden Mittelwert (Moving average) über N-Abtastwerte und einer anschließenden Datenreduktion (Dezimation) von N.

Effektive Auflösung bei "Averaging-Betrieb" Mittelwertbildung

Während man mit 16-Bit im 2,5V Bereich ($\pm$1,25V) eine Auflösung von $2,5/2^{16}=38,14\mu V$ für 1 LSB erhält, beträgt die Auflösung bei 20-Bit $2,5/2^{20}= 2,384\mu V$ pro 1 LSB. Die Auflösung mittels "Averaging" bei 20-Bit weicht nicht von einem idealen 20-Bit A/D-Umsetzer ab, wohl aber der "Full-Scale-Bereich". Auf der Testumgebung befindet sich ein 12-Bit-Wandler, dessen Ausgangsdaten beim "Averaging" durch Addition von 2048 (oder 1024, 512, 256, 128, 64) Werten zu einem Ausgabewort im Microcontroller zusammengefasst werden. Unter der Vorraussetzung, dass bei diesem 12-Bit-Wandler $2^{12}-1$ Werte zur Verfügung stehen, lässt sich der maximale digitale Eingangswert bei 2048-fachen "Averaging" berechnen zu:

$$4096 \bullet 2048 = 8388608 = 00800000_{HEX}$$

(Wert des A/D-Wandler [$2^{12}-1$] * $2^{11}$-fachem "Averaging" = 8388608); Das maximal mögliche binäre Ausgabewort betragt somit:

```
0080000    HEX
0000 0000    1000 0000 0000 0000 0000 0000 BIN
```

Für eine Auflösung von 20-Bit werden nun die letzten drei Bit mit Hilfe des Microcontrollers abgeschnitten, wodurch sich ein Full-Scale-Range von

```
F      F      F      F      0      Hex
1111   1111   1111   1111   0000   BIN
```

ergibt. Der gesamte Eingangsspannungsbereich beträgt demnach
FFFF0 hex 2,384$\mu$V = 2,49976704V.
Die maximale Eingangsspannung, die im $\pm$1,25V Bereich noch korrekt gemessen werden kann, ist 2,49976704V - 1,25V = 1,24976704V. Die Abweichung zu +1,25V beträgt demnach 232,96$\mu$V, während bei einem reinen 20-Bit-Wandler nur eine Abweichung von 2,384$\mu$V vorhanden wäre. Der Eingangsspannungsbereich im "Averaging-Modus" erstreckt sich also bei einer 20-Bit Auflösung von -1,25V bis +1,24976704V.

Wird die Anzahl der Additionswerte beim "Averaging" reduziert, findet jedoch keine weitere Reduzierung des Full-Scale-Range statt. Die Auflösung beträgt nach wie vor 2,384$\mu$V pro 1 LSB. Durch das "Averaging" wird zwar die Auflösung von 610 $\mu$V auf 2,384$\mu$V pro LSB erhöht, die integrale Linearität des gesamten Systems hängt jedoch auch weiterhin nur von der des A/D-Wandlers ab. Diese entspricht hier maximal 12-Bit.

Unterdrückung der Frequenz von 25Hz/30Hz und deren Vielfachen

Durch geeignete Wahl der Abtastfrequenz des A/D-Wandlers, der Anzahl der Messwerte (Averaging) pro Messzyklus und der Einschwingzeit können ganz gezielt bestimmte Störfrequenzen unterdrückt werden. Im Ausführungsbeispiel schwingt der Quarz-Oszillator mit einer Frequenz von 25,6MHz. Diese Frequenz wird um den Faktor 128 im Microcontroller geteilt, so dass eine Frequenz von 200KHz entsteht. Die 200KHz werden als Abtastfrequenz für den ADC verwendet. Wird nun eine Mittelwertbildung mit 2048 Messwerten durchgeführt, so berechnet sich die Messwerterfassungszeit zu:

$$T = \left[ \frac{1}{f_{sample}} \cdot Anzahl \cdot der \cdot Messwerte \right]$$

mit den oben angegebenen Werten erhalten wir bei 2048 Messwerten:

$$T = \left[ \frac{1}{200KHz} \cdot 2048 \right] = 10{,}24 ms$$

Um nun aber die Frequenz von 25Hz oder deren Vielfache wie z. B. die Netzfrequenz (50Hz) unterdrücken zu können, muss ein Messzyklus genau 40ms sein. Dies bedeutet, dass die verbleibende Zeit von 40ms -10,24ms = 29,76ms. dazu verwendet werden kann, um das Eingangsspannungssignal einschwingen zu lassen. Dabei wird nach jedem Umschalten des Multiplexers eine gewisse Zeit gewartet, bis die internen Filter eingeschwungen sind und ihren Endwert erreicht haben. Sollte ein passives Eingangsfilter mit höheren Zeitkonstanten als vorher beschrieben, verwendet werden, muss auch dieses Filter eingeschwungen sein, bevor mit der Messung begonnen wird. Des Weiteren ist noch zu beachten, dass bei der Anwendung der "Chopper-Technik" während eines Messzyklus das Eingangsspannungssignal durch den Multiplexer 4 mal in seiner Polarität geändert wird. Deshalb benötigt man, wie in Fig. 8 gezeigt, insgesamt vier Einschwingzeiten. Unter der Vorraussetzung, dass eine 25Hz Unterdrückung bei 2048 Messwerten stattfinden soll, ergibt sich eine Einschwingzeit des Signals für alle beteiligten Baugruppen

von 29,76ms/4 = 7,44ms.

Wird das zu messende Nutzsignal von einer Störquelle mit 25Hz überlagert, werden bei einer Mittelwertbildung von insgesamt 2048 Messwerten, 1024 Werte mit der positiven Halbwelle und die übrigen 1024 Werte mit der negativen Halbwelle der Störfrequenz bewertet. Nach 40ms sind alle 2048 Messwerte in den Microcontroller eingelesen und deren arithmetischer Mittelwert ist gebildet. Dabei wird natürlich auch der arithmetische Mittelwert der Störsignale berechnet. Dieser ist bei symmetrischen Signalen wie z. B. beim Sinus Null. Die Störfrequenz von 25Hz wird demnach unterdrückt. Dies bedeutet, dass eine dem Nutzsignal überlagerte Störfrequenz von 25Hz (oder ein Vielfaches dieser Frequenz: 50Hz, 75Hz, 100Hz, 125Hz etc.) unter den oben genannten Bedingungen keine unerwünschten Auswirkungen auf die eigentliche Messung hat.

In der Übertragungsfunktion über der Frequenz erkennt man die Nullstellen bei 25Hz, 50Hz, 75Hz, 100Hz etc.. Diese Art von Filter mit mehreren Nullstellen (Notch) ist auch unter der Bezeichnung Kammfilter bekannt. (Funktion sinx/x). Bei genauerer Betrachtung ist zu erkennen, dass Eingangsspannungssignale ab ca. 10Hz mit 20dB/dekade durch das "Averaging" bedämpft werden. Es zeigt sich, dass es bei hohen Frequenzen keine große Rolle mehr spielt, ob nun exakt über eine ganzzahlige Anzahl von Sinusperioden gemessen wird.

Offset-Unterdrückung durch die "Chopper-Funktion"

Viele Sensorsignale im mV-Bereich sind mit einem Gleichspannungs-Offset beaufschlagt, der die absolute Messung verfälscht. Neben diesem Offset-Fehler sind Offset-Drift und niederfrequentes 1/f-Rauschen Einflussfaktoren, die das Messergebnis verändern. Das schränkt die erreichbare Reproduzierbarkeit und Auflösung erheblich ein. Um diese Fehlergrößen zu reduzieren, ist eine sogenannte "Chopper-Funktion" in den Analog/Digital-Wandler integriert.

Die zu messende Spannung wird als Eingangsspannungssignal an einen Eingang und mit umgekehrter Polarität an den zweiten Eingang des Multiplexers angelegt. Nun wird das erste Viertel aller Werte der gesamten Messung z. B. über Schalterstellung 0 eingelesen. Das zweite Viertel der Messwerte gelangt über Schalterstellung 1 (mit umgekehrter Polarität) an den A/D-Wandler. Das dritte Viertel wird wieder über Kanal 0 und das letzte Viertel wieder über Kanal 1 eingelesen. Dies hat zur Folge, dass die Messspannung X(z) in beiden Schalterstellungen positiv zum Ergebnis M(z) aufaddiert wird.

Die Störgröße y(z) umfasst alle Störspannungen, die sich während der Signalaufbereitung und A/D-Wandlung der Messspannung überlagern. Die Störspannung wird in der oberen Schalterstellung positiv, in der unteren negativ zum Ergebnis M(z) addiert. Störspannungen, die während einer kompletten Messperiode konstant sind, werden dadurch ausgelöscht. DC-Störer wie Offsetfehler vom Multiplexer und des SAR-ADC werden somit unterdrückt. Nachdem die Gesamtsumme durch die Anzahl der Messwerte geteilt wurde, kann das korrekte Ergebnis bestimmt werden mit der Formel:

$$\sum(Me\beta werteKanal 1) - \sum(Me\beta werteKanal 2)/(AnzahlderMe\beta werte)$$

Wird z.B. ein Messwert von +1V bestimmt, würde er bei einfacher Messung durch einen Offset verfälscht gemessen würde. Bei der "Chopper-Funktion" wird die Spannung von + 1 V wie üblich an den ersten Schalter (Schalterstellung 0) des Multiplexer angelegt. An den zweiten Schalter (Schalterstellung 1) wird nun die gleiche Spannung, jedoch mit umgekehrter Polarität angeschlossen. Unter der Annahme, dass die resultierende Offsetspannung aller Bauteile +1 mV beträgt, werden folgende Werte eingelesen:

<div align="center">

**Kanal 1 = +1.001V , Kanal 2 = -0.999V**

</div>

Diese Messwerte werden im Microcontroller nach der oben aufgeführten Formel addiert und durch die Anzahl der Messwerte wieder geteilt.

$$[+1,001V - (-0,999V)]/2 = 1V$$

Dies führt also zu einem Messergebnis, welches im Idealfall frei von jeglichen Offsetspannungen ist. Des weiteren wird auch die Offset-Drift (verursacht durch Temperatur, etc.) mit dieser "Chopper-Technik" stark unterdrückt. Es werden alle konstanten Störspannungen gemindert, die sich zwischen Analogschalter und Microcontroller der Messspannung überlagern. Aber auch das 1/f-Rauschen, speziell des Eingangsverstärkers, erfährt mit zunehmender "Chopper-Frequenz" (d.h. mehrfaches Umschalten in einem Messzyklus) eine stärkere Dämpfung.

Bei diesem Verfahren werden also die Offset-Spannungen unterdrückt, welche durch die Bauteile erzeugt werden. An dieser Stelle sei noch erwähnt, dass die "Chopper-Funktion" natürlich ohne Mittelwertbildung nicht möglich ist, da beim "Choppern" mehrere Messwerte des identischen Signals eingelesen werden müssen. Beim "Chopper" werden für ein Eingangsspannungssignal zwei Multiplexerkanäle benötigt.

Der andere Kanal wird für schnelle Einzelmessungen mit 12 Bit Auflösung verwendet. Wird nun während einer Messzeit von 40ms (25Hz) das Eingangsspannungssignal viermal umgepolt, so ist auch die Periodendauer des "Choppers" viermal kleiner (10ms). Dies entspricht einer "Chopper-Frequenz" von 100Hz.

Fig. 2 zeigt die Chopper-Topologie des Analog /Digital Wandlers im Detail mit Gleichtaktfilter.

Das Herzstück auf der Digitalseite bildet ein hoch performanter Microcontroller 10 (MCU). Dieser wird über ein internes E$^2$-PROM konfiguriert. Der MCU steuert zum einen den Chopper Timing Sequencer und verarbeitet den Datenstrom aus der Vielzahl der Samples und errechnet den Mittelwert. Mit der Nutzung der unteren Schalterstellung von S5 und S6 und der gegenpoligen Umschaltung der Eingangsschalter S1, S2 bzw. S3, S4 wird die schnelle Einzelmessung aktiviert mit maximaler Abtastrate des SAR-Wandlers. Somit kann der Anwender gemäß den Anforderungen, sehr schnell mit 12 Bit Genauigkeit die erste Messung starten und verarbeiten und nach 20ms ein 16 Bit bis 20Bit Mittelwertergebnis am MCU abholen.

Signalflussbeschreibung des Gesamtsystems

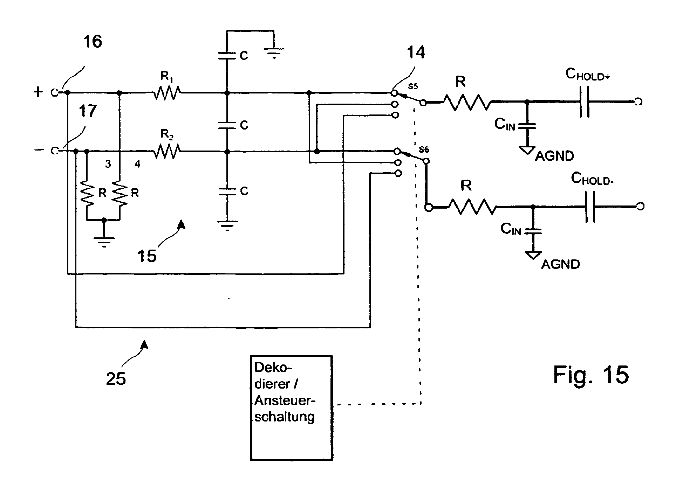

Das analoge Eingangsspannungssignal wird zuerst über den differenziellen Eingang 25 in Fig. 2 und der Schalterstellung 3 des Multiplexers 14 zum Microcontroller geführt. In der Praxis werden die Anschlüsse 16 ,17 und 25 in Fig.2 verbunden und damit in der Schalterstellung 3 des Multiplexers 14 in Fig.2 das Eingangsfilter 15 überbrückt. Fig. 15 zeigt die Anschluss-Konfiguration. Diese erste schnelle Messung und Analog/Digital-Wandlung des Signals arbeitet nach dem SAR-Wandlungsprinzip. Für die Echtzeitfähigkeit in digitalen Regelkreisen ist dies die schnelle und direkte Durchleitung dieses Signals zum Prozessor. Dieses Wandlungsergebnis entspricht der Messung 1 in Fig.13. Damit ist eine schnelle Einzelmessung in Echtzeit mit maximaler Abtastrate des SAR-Wandlers möglich.

Die zweite und alle folgenden Messung wird über die Anschlüsse 16 und 17 und über das Eingangsfilter 15 in Fig. 2 und der Schalterstellung 1 und 2 des Multiplexers 14 in Fig.2 geführt, der als Chopper-Stufe arbeitet. Somit kann der Anwender gemäß den Anforderungen, sehr schnell mit 12 Bit Genauigkeit die erste Messung starten und verarbeiten und nach beispielsweise 20ms (Zeit für die Mittelwertbildung) ein 16 Bit bis 20Bit Mittelwertergebnis am Microcontroller abholen. Damit wird die Kombination aus schneller Wechselspannungsmesstechnik (AC-Messung) und genauer Gleichspannungsmesstechnik (DC-Messung) ermöglicht.

Das zu messende Signal wird gemäß Fig. 2,4 über die Anschlüsse 16 und 17 geführt. Bei der Differenzmessung werden diese Anschlüsse für jede Signalquelle als Signalleitung 16 und Signalbezugsleitung 17 ausgebildet und über den Differenz-Multiplexerkanal 18 geführt. Die Gleichtaktspannung an den Differenzeingängen des ADC's bezieht sich auf die Masseleitung. Die Widerstände R1, R2, R3, R4 bilden zusammen mit den Kondensatoren C2, C3, C4 das Eingangsfilter 15. Das Eingangsspannungssignal gelangt über den passiven Tiefpass an einen der differenziellen Eingänge des internen Multiplexers 14.

Über die Chopperschalter S5 und S6 wird das zu messende Signal in Schalterstellung 1 wie oben beschrieben abgetastet und gewandelt. In Schalterstellung 2 wird das zu messende Signal verpolt (Anschlüsse werden getauscht) gemessen. Die Steuerung der Chopperschalter übernimmt der Microcontroller 10, der über das Steuerwerk 24 die Chopperstufe 19 steuert. In Schalterstellung 3 ist es möglich, ohne Verwendung des Eingangsfilters 15 und ohne Verwendung der Chopperfunktion die Signale mit maximaler Geschwindigkeit (maximale Sample Rate) zu wandeln. Dies ist der Fast Sampling Mode zur Erfassung von dynamischen Signalen.

Die zu messenden Signale gelangen über die Serienwiderstände R des Multiplexers an die beiden Hold-Kondensatoren 21. Jetzt findet die Differenzbildung statt. Die Ladung von $C_{HOLD+}$ wird von $C_{HOLD-}$ subtrahiert. Diese Differenz-Ladung entspricht einer proportionalen Spannung, die im SAR-Wandler verarbeitet wird.

Kennzeichnend für die Funktion ist die Annäherung eines Vergleichswertes an den analogen Wert des zu messenden Signals. Ein genaues und schnelles Umsetzen wird erreicht, indem die Umsetzung redundant erfolgt, also pro Schritt nur ein Teil eines Bits umgesetzt wird. Der Analog/Digital Wandler ADC grenzt das eingehende Signal mittels Intervallschachtelung ein. Dazu besitzt er ein Datenregister (SAR) 11, in dem zum Schluss der ermittelte digitale Wert steht, den Digital-Analog-Umsetzer 12, der eine dem momentanen Digitalwert des Datenregisters entsprechende analoge Referenzspannung erzeugt, einen Komparator 13, der die erzeugte Referenzspannung 23 mit dem Eingangsspannungssignal vergleicht, und das Steuerwerk 24. Für jedes Bit an Genauigkeit benötigt ein einfacher ADU jeweils einen Taktzyklus Umsetzungszeit.

Das Steuerwerk 24 schiebt die Daten zum Microcontroller 10, der folgende Aufgaben hat:

- Bedarfsweise Addition eines digitalen Dither-Signales gemäß Fig. 10 zur Erhöhung der Auflösung bei kleinen Signalen, der Dither ist über einen Schalter zuschaltbar.
- Zeitlich synchrone Steuerung der Chopperstufe 19 unter Berücksichtigung der Einschwingzeit der Eingangsfilter und RC-Zeitkonstanten des Systems gemäß Fig.8.
- Addition der digitalen Werte (hier am Beispiel 1024 Messwerte) innerhalb einer halben Periode (negative Halbwelle) der Störspannung.
- Addition der digitalen Werte (hier am Beispiel 1024 Messwerte) innerhalb einer halben Perioden (positive Halbwelle) der Störspannung.
- Errechnung eines digitalen Wortes als hochauflösendes Messergebnisses durch Differenzbildung aus beiden Halbwellen.
- Umschaltung der Chopperstufe 19 in den Fast Sampling Mode.
- Ausgabe des Messergebnisses mit einer Auflösung von 20Bit und mehr.

Typische Kenndaten und Spezifikationen des im Ausführungsbeispiel dargestellten Systems sind:

- Eingangsspannungsbereich $\pm V_{REF} / 2$
- Verwendung einer internen oder externen Referenzspannung
- Auflösung 12, 16, 18, 20-Bit
- Integrale Linearität von 12 Bit oder mehr
- 4 differenzielle Eingangskanäle
- Hohe Gleichtaktunterdrückung durch differenzielle Eingänge
- Symmetrisches Tiefpassfilter von 256Hz
- Digitale Filterung durch Mittelwertbildung aus 64, 128, 256, 512, 1024, 2048 Werten (mit gleichzeitiger Unterdrückung der Netzfrequenz von 50Hz/60Hz und deren Vielfache)
- Hohe Abtastfrequenz (>= 200KHz) im Single Shot Mode(Einzelmessung), Echtzeitfähigkeit z.B. in Regelkreisen
- Geringe Latenzzeit bei Einzelmessung
- Chopper-Technik zur Unterdrückung des Signal-Offset im Rahmen des Gleichtaktbereichs des A/D-Wandlers
- Zeitsynchrone Ablaufsteuerung der Chopper-Eingangsstufe
- Reproduzierbare hochauflösende Messungen
- Hervorragendes Preis/Leistungsverhältnis der Topologie

Die Erfindung auf Basis eines SAR-Analog/Digital-Wandler hat folgende Eigenschaften:

- Mehrere Eingangsspannungssignale können über Multiplexer gemessen werden
- Erfasst in Echtzeit einen "Schnappschuss" des zumessenden Signals
- Kann mit externen Taktsignalen synchronisiert werden
- Einschwingzeit wird durch die Größe des MSB-Kondensators (Sample&Hold Stufe) bestimmt
- Schnelle Sprungantwort ideal für schnelle digital geregelte Systeme ohne Totzeit

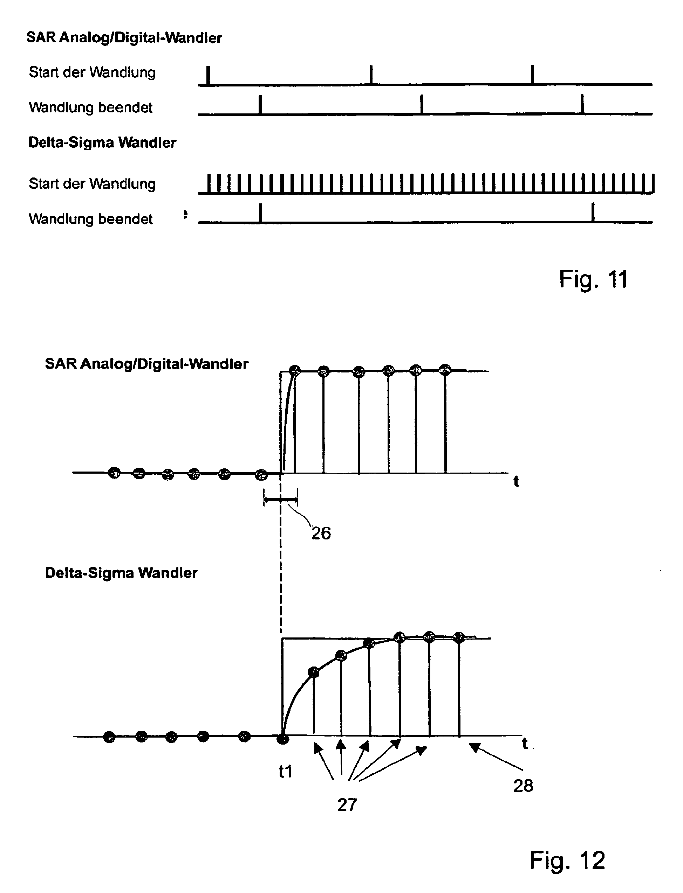

Die Fig. 11 bis 14 verdeutlichen den Unterschied zwischen einer Lösung mit einem Delta Sigma Wandler nach dem Stand und der erfindungsgemäßen Lösung mit einer SAR-Topologie. In Fig. 11 wird das Delta-Sigma Prinzip im Vergleich zum SAR-Prinzip dargestellt. In Fig. 11 oben ist die Arbeitsweise eines SAR Wandlers, in Fig. 11 unten die Arbeitsweise eines Delta-Sigma Wandlers dargestellt. Deutlich ist zu erkennen, dass die SAR Analog/Digital Wandlung mit einem definierten Start und einem davon abhängigen Wandlungssignal arbeitet. Die Delta-Sigma Analog /Digital Wandlung arbeitet kontinuierlich im Sampling/Wandlungs-Modus, jedoch wird ein längerer Zeitraum für die Wandlung benötigt.

Dies wird auch deutlich, wenn in Fig. 12 das Einschwingzeitverhalten der SAR-Topologie im Vergleich zur Delta-Sigma-Topologie ohne Berücksichtigung eines digitalen Filters betrachtet wird. Liegt das Eingangsspannungssignal zum Zeitpunkt t1 am Wandler an, so wandelt in Fig. 12 oben der SAR-Wandler dieses Signal kurzzeitig in ein digitales Signal um. Bereits nach der ersten Wandlung 26 ist das digitale Signal mit hoher Genauigkeit gültig, da der SAR-Wandler zu jedem beliebigen Zeitpunkt eines definierten Ereignisses das Signal erfassen und in ein digitales Signal umwandeln kann. Vergleicht man dies mit dem Delta-Sigma Wandler in Fig. 12 unten, so erfolgen, wenn das Eingangssignal zum Zeitpunkt t1 anliegt, mehrere ungültige Wandlungen 27 , bei denen das digitales Ausgangssignal nicht dem Eingangsspannungssignal entspricht, bevor ein erstes eingeschwungenes Wandlungsergebnis 28 vorliegt. Der Delta-Sigma Wandler benötigt mehrere Wandlungszyklen als Einschwingzeit.

Wird gemäß Fig. 13 im Zeitverhalten eine identischen Wandlungsrate mit der Verarbeitung von zehn Wandlungsergebnissen im digitalen Filter berücksichtigt, ergibt sich im Vergleich zwischen den beiden Wandlern eine Latenzzeit Lt. Wird zudem erfindungsgemäß die schnelle chopper-basierende SAR-Topologie bei den zehn Wandlungsergebnissen im digitalen Filter berücksichtigt, wird diese Latenzzeit LT deutlich größer, d.h. der Delta-Sigma Wandler ist deutlich langsamer als die erfindungsgemäße Lösung.

Eine Anwendungsbereich ist die Entwicklung eines neuen echtzeitfähigen elektronischen Bremsassistenten für Kraftfahrzeuge basierend auf einem vollständig digital geregelten System. Mit dem Einzug von digitalen Echtzeit-Bussystemen in Fahrzeugen zur Steuerung und Regelung der Komponenten ist das Zeit- und Frequenzverhalten eines Analog/DigitalWandlers eine entscheidende Größe zur Stabilität und des Schwingungsverhaltens in geschlossenen und speziell in überlagerten Regelkreisen. Bei einer Bremsregelung z.B. werden zeitgleich alle vier Bremsen digital geregelt. Weitere überlagerte Regelkreise zur Stabilisierung des Fahrzeugs während des Bremsvorgangs sind ebenfalls vorhanden.

Der Bremsassistent hat die Aufgabe auf leichtem Pedaldruck oder bei Gaswechsel schnell zu reagieren und die Bremskolben leicht an die Bremsscheibe anzulegen. Hierzu ist eine extrem schnelle Sprungantwort des Regelsystems notwendig mit einer mittleren bis guten Genauigkeit (erste schnelle Messung ohne Verzögerung und ohne Totzeit). Kommt es dann zum eigentlichen Bremsvorgang wird die Bremsung mit einer äußerst sensiblen Abstimmung und feiner Dosierung mit hoher Genauigkeit durchgeführt (hohe Auflösung, hohe Genauigkeit, geringer Offset). Ein Delta-Sigma A/D-Wandler basierendes System kann diese Aufgabe nicht erfüllen. Die gleichen Problemstellungen sind generell bei Positionieraufgaben der digital geregelten Robotik (Mehrachsenantriebe) oder in Motorsteuerungen vorhanden, z.B. Schweißroboter.

**Bezugszeichenliste**

| 10 | Microcontroller |
|---|---|
| 11 | SAR-Topologie |
| 12 | Digital/Analog-Wandler |
| 13 | Vergleicher |
| 14 | Multiplexer |

| 15 | differenzielles Eingangsfilter |
| 16 | Signalleitung |
| 17 | Signalbezugsleitung< |
| 18 | Multiplexerkanal |
| 19 | Chopper-Stufe |
| 20 | Masse |
| 21 | Hold-Kondenatoren |
| 22 | Verzögerungsglied |
| 23 | Referenzspannung |
| 24 | Additionsstufe für Dithersignal |
| 25 | differenzieller Eingang |
| 26 | Wandlung |
| 27 | ungültige Wandlung |
| 28 | eingeschwungenes Wandlungsergebnis |
| C2,C3,C4 | Kondensatoren |
| Lt | Latenzzeit |
| S5,S6 | Chopperschalter |
| R1,R2,R3,R4 | Widerstände |

**Patentansprüche**

1. Analog/Digitalwandler zur Absolutmesswertbestimmung, mit

- einem Microcontrofler (10),
- einer SAR-Topologie (11) zur Erzeugung eines momentanen digitalen Werts in Folge eines Eingangsspannungssignals mittels Intervallschachtelung.
- einem Digital/Analogwandler (12), der eine dem momentanen digitalen Wert entsprechende Referenzspannung erzeugt,
- einem Vergleicher (13) zum Vergleich der Referenzspannung mit dem Eingangsspannungssignal des Analog/Digitalwandlers,
- einem Multiplexer (14, 18) für den Multiplex-Betrieb mehrerer Signalquellen,

**dadurch gekennzeichnet, dass** ein differenzieller Eingangsfilter (15) vorgesehen ist,
wobei das Eingangsspannungssignal als ein überabgetastetes Eingangsspannungssignal und als differenzielles Eingangssignal für jede Signalquelle mittels einer Signalleitung (16) und einer Signalbezugsleitung (17) dem Multiplexer mit differenziellen Eingangskanälen zugeführt ist,
dass eine hinter dem differenZiellen Eingangsfilter angeordnete, durch den Multiplexer (14) gebildete Chopper-Stufe (19) vorgesehen ist, wobei das Eingangsspannungssignal an einem ersten Eingang des Multiplexers und invertiert an einem zweiten Eingang des Multiplexers (14) zur Verringerung oder Eliminierung von Gleichspannungsoffsetanteilen des Eingangsspannungssignals durch die Verwendung der Chopper-Stufe (19) angelegt ist, und

17

dass ein digitaler Mittelwertbildner zur Mittelwertbildung des überabgetasteten Eingangsspannungssignals vorgesehen ist,

wobei ein weiterer differenzieller Eingang (25) vorgesehen ist, über den das Eingangsspannungssignal für wenigstens eine Analog-/Digital-Wandlung (26) eines ersten Abtastwerts das Eingangsfilter (15) überbrückt.

2. Analog/Digitalwandler nach Anspruch 1, **dadurch gekennzeichnet, dass** eine Additionsstufe (24) zur Addition eines Dither-Signals zum digitalen Wert vorgesehen ist.

3. Analog/Digitalwandler nach Anspruch 1 oder 2, **dadurch gekennzeichnet, dass** sich die Differenzeingänge des differenzieilen Eingangsfilters (15) auf Masse (20) beziehen, wobei vorzugsweise wenigstens ein hochohmiger Widerstand (R3, R4) von wenigstens einem der beiden Eingänge des differenziellen Eingangsfilters (15) zur Masse (20) vorgesehen ist, wobei die Größe des wenigstens einen Widerstands so gewählt ist, dass die Differenzspannung kleiner als die gewünschte Messgenauigkeit des Systems ist.

4. Analog/Digitalwandler nach einem der vorhergehenden Ansprüche, **dadurch gekennzeichnet, dass** dem differenziellen Eingangsfilter (15) ein symmetrischer HF-Filter zugeordnet ist, der wenigstens zwei Kondensatoren (C3, C4) vorzugsweise gegen Masse (20) umfasst.

5. Analog/Digitalwandler nach Anspruch 4, **dadurch gekennzeichnet, dass** wenigstens ein Kondensator (C2) vorgesehen ist, der parallel zu einer Differenzquelle für das differenzielle Eingangssignal angeordnet ist, wobei der Wert des Kondensators (C2) viel grö-βer ist als der Wert der Kondensatoren (C3, C4) des symmetrischen HF-Filters und/oder wobei der Kondensator (C2) bei einer gewünschten Genauigkeit von X Bit um den Faktor $2^x$ größer ist als in Reihe geschaltete Multiplexerkapazitäten $C_{MUX}$ (21).

6. Analog/Digitatwandler nach einem der vorhergehenden Ansprüche, **dadurch gekennzeichnet, dass** ein Verzögerungsglied zur Zeitverzögerung zwischen dem Umschaltzeitpunkt des Multiplexers und dem Abtastzeitpunkt des Analog/Digitalwandlers vorgesehen ist.

7. Analog/Digitalwandler nach einem der vorhergehenden Ansprüche, **dadurch gekennzeichnet, dass** ein Kammfilter zur Einstellung oder Regelung der Chopper-Abtastfrequenz vorgesehen ist, der zur gezielten Unterdrückung von Störfrequenzen die Einschwingzeit des Multiplexers steuert oder regelt.

8. Analog/Digitalwandler nach einem der vorhergehenden Ansprüche, **dadurch gekennzeichnet, dass** er für einen echtzeitfähigen elektronischen Bremsassistenten für Kraftfahrzeuge basierend auf einem digital geregelten System bestimmt ist.

9. Verfahren zur Bestimmung von Absolutmesswerten, mit einem Analog/Digitalwandler mit einem Microcontroller (10), einem Multiplexer (14, 18) und einer SAR-Topologie (11), die einen momentanen digitalen Wert auf Grund eines Eingangsspannungssignals mittels Intervallschachtelung erzeugt, sowie mit einem Digital/Analog-Wandler (12), der eine dem momentanen digitalen Wert entsprechende Referenzspannung erzeugt, die in einem Vergleicher (13) mit dem Eingangsspannungssignal des Analog/Digitalwandlers verglichen wird,

**dadurch gekennzeichnet, dass** für ein differenzielles Eingangsfilter (15) das Eingangsspannungssignal als überabgetastetes Eingangsspannungssignal und als ein differenzielles Eingangssignal für jede Signalquelle mittels einer Signalleitung (16) und einer Signalbezugsleitung (17) dem Multiplexer mit differenziellen Eingangskanälen zugeführt wird,

dass das Eingangsspannungssignal an eine hinter dem differenziellen Eingangsfilter angeordnete, durch den Multiplexer (14, 18) gebildete Chopper-Stufe (19) angelegt wird , wobei das Eingangsspannungssignal an einem ersten Eingang des Multiplexers und invertiert an einem zweiten Eingang des Multiplexers zur Verringerung oder Eliminierung von Gleichspannungsoffsetanteilen des Eingangsspannungssignals angelegt wird,

dass aus dem überabgetasteten Eingangsspannungssignal ein digitaler Mittelwert des Eingangsspannungssignals gebildet wird, und

dass das Eingangsfilter (15) für das Eingangsspannungssignal mittels eines weiteren differenziellen Eingangs (25) für wenigstens eine Analog-/Digital-Wandlung (26) eines ersten Abtastwerts überbrückt wird.

10. Verfahren nach Anspruch 9, **dadurch gekennzeichnet, dass** ein Dither-Signal dem digitalen Wert hinzuaddiert wird.

11. Verfahren nach Anspruch 9 oder 10, **dadurch gekennzeichnet, dass** sich die Differenzeingänge des differenziellen Eingangsfilters (15) auf Masse (20) beziehen.

**12.** Verfahren nach einem der vorhergehenden Ansprüche 9 bis 11, **dadurch gekennzeichnet, dass** wenigstens ein hochohmiger Widerstand (R3, R4) von wenigstens einem der beiden Eingänge des differenzialen Eingangsfilters (15) zur Masse (20) angeordnet ist, wobei die Größe des wenigstens einen Widerstands so gewählt wird, dass die Differenzspannung kleiner als die gewünschte Messgenauigkeit des Systems ist.

**13.** Verfahren nach einem der vorhergehenden Ansprüche 9 bis 12, **dadurch gekennzeichnet, dass** die Zeit zwischen dem Umschaltzeitpunkt des Multiplexers und dem Abtastzeitpunkt des Analog/Digitalwandlers durch ein Verzögerungsglied verzögert wird.

**14.** Verfahren nach einem der vorhergehenden Ansprüche 9 bis 13, **dadurch gekennzeichnet, dass** ein Kammfilter zu Beeinflussung der Chopper-Abtastfrequenz die Einschwingzeit des Multiplexers steuert oder regelt.

**15.** Verfahren nach einem der vorhergehenden Ansprüche 9 bis 14, **dadurch gekennzeichnet, dass** es an einem echtzeitfähigen elektronischen Bremsassistenten für Kraftfahrzeuge basierend auf einem digital geregelten System verwendet wird.

**Claims**

**1.** An analogue/digital converter for determining absolute measured values, comprising

- a microcontroller (10),
- an SAR topology (11) for the production of an instantaneous digital value as a result of an input voltage signal by means of a nested-interval process,
- a digital/analogue converter (12) which produces a reference voltage corresponding to the instantaneous digital value,
- a comparator (13) for comparing the reference voltage with the input voltage signal of the analogue/digital converter,
- a multiplexer (14, 18) for multiplexing a plurality of signal sources,

**characterized in that** there is provided a differential input filter (15), wherein the input voltage signal is supplied to the multiplexer using differential input channels as an over-sampled input voltage signal and as a differential input signal for each signal source by means of a signal line (16) and a signal reference line (17),
**in that** there is provided a chopper stage (19) which is formed by the multiplexer (14) and is arranged after the differential input filter, wherein the input voltage signal is applied to a first input of the multiplexer and is applied inverted to a second input of the multiplexer (14) for the purposes of reducing or eliminating DC voltage offset components of the input voltage signal due to the use of the chopper stage (19), and
**in that** there is provided a digital average value forming means for forming the average value of the over-sampled input voltage signal,
wherein there is provided a further differential input (25) via which the input voltage signal bypasses the input filter (15) for at least one analogue/digital conversion (26) of a first sampling value.

**2.** An analogue/digital converter in accordance with Claim 1, **characterized in that** an adder stage (24) is provided for the purposes of adding a dither signal to the digital value.

**3.** An analogue/digital converter in accordance with Claim 1 or 2, **characterized in that** the differential inputs of the differential input filter (15) are referenced to earth (20), wherein at least one high impedance resistance (R3, R4) is preferably provided between at least one of the two inputs of the differential input filter (15) and earth (20), wherein the magnitude of the at least one resistance is selected in such a manner that the differential voltage is smaller than the desired measuring accuracy of the system.

**4.** An analogue/digital converter in accordance with any of the preceding Claims, **characterized in that** the differential input filter (15) has associated therewith a symmetrical HF filter which comprises at least two capacitors (C3, C4) that are preferably earthed (20).

**5.** An analogue/digital converter in accordance with Claim 4, **characterized in that** there is provided at least one capacitor (C2) which is arranged in parallel with a difference source for the differential input signal, wherein the value of the capacitor (C2) is much larger than the value of the capacitors (C3, C4) of the symmetrical HF filter and/or wherein, for a desired accuracy of X bits, the capacitor (C2) is larger by a factor $2^x$ than series connected multiplexer capacitances $C_{Mux}$ (21).

6. An analogue/digital converter in accordance with any of the preceding Claims, **characterized in that** there is provided a delay member for producing a time delay between the switching time point of the multiplexer and the sampling time point of the analogue/digital converter.

7. An analogue/digital converter in accordance with any of the preceding Claims, **characterized in that** there is provided a comb filter for setting or regulating the chopper sampling frequency which controls or regulates the response time of the multiplexer for the purposes of controlled suppression of spurious frequencies.

8. Analogue/digital converter in accordance with any of the preceding Claims, **characterized in that** it is intended for an electronic braking assistant for motor vehicles based on a digitally regulated system which is operable in real time.

9. A method for the determination of absolute measured values using an analogue/digital converter comprising a microcontroller (10), a multiplexer (14, 18) and an SAR topology (11) which produces an instantaneous digital value on the basis of an input voltage signal by means of a nested-interval process, and also a digital/analogue converter (12) which produces a reference voltage that corresponds to the instantaneous digital value and is compared with the input voltage signal of the analogue/digital converter in a comparator (13), **characterized in that**, for a differential input filter (15), the input voltage signal is supplied to the multiplexer using differential input channels in the form of an over-sampled input voltage signal and a differential input signal for each signal source by means of a signal line (16) and a signal reference line (17),
**in that** the input voltage signal is applied to a chopper stage (19) which is arranged after the differential input filter and is formed by the multiplexer (14, 18), wherein the input voltage signal is applied to a first input of the multiplexer and is applied inverted to a second input of the multiplexer for the purposes of decreasing or eliminating DC voltage offset components of the input voltage signal,
**in that** a digital average value of the input voltage signal is formed from the over-sampled input voltage signal, and
**in that** the input filter (15) is bypassed for the input voltage signal by means of a further differential input (25) for at least one analogue/digital conversion (26) of a first sampling value.

10. A method in accordance with Claim 9, **characterized in that** a dither signal is added to the digital value.

11. A method in accordance with Claim 9 or 10, **characterized in that** the differential inputs of the differential input filter (15) are referenced to earth (20).

12. A method in accordance with any of the preceding Claims 9 to 11, **characterized in that** at least one high impedance resistance (R3, R4) is arranged between at least one of the two inputs of the differential input filter (15) and earth (20), wherein the magnitude of the at least one resistance is selected in such a way that the differential voltage is smaller than the desired measuring accuracy of the system.

13. A method in accordance with any of the preceding Claims 9 to 12, **characterized in that** the time period between the switching time point of the multiplexer and the sampling time point of the analogue/digital converter is delayed by a delay member.

14. A method in accordance with any of the preceding Claims 9 to 13, **characterized in that** a comb filter controls or regulates the response time of the multiplexer for the purposes of affecting the chopper sampling frequency.

15. A method in accordance with any of the preceding Claims 9 to 14, **characterized in that** it is used in an electronic brake assistant for motor vehicles based on a digitally regulated system which is operable in real time.

**Revendications**

1. Convertisseur analogique-numérique pour l'évaluation de valeurs mesures absolues, comprenant :

    - un microcontrôleur(10),
    - une topologie SAR (11) pour la production d'une valeur numérique momentanée en réponse à un signal de tension d'entrée au moyen d'un emboîtement d'intervalles,

- un convertisseur analogique-numérique (12) produisant une tension de référence correspondant à la valeur numérique momentanée,
- un comparateur (13) pour la comparaison de la tension de référence au signal de tension d'entrée du convertisseur analogique-numérique,
- un multiplexeur (14,18) pour l'actionnement multiplexé de plusieurs sources de signal,

**caractérisé en ce qu'**il est prévu un filtre d'entrée différentiel (15), le signal de tension d'entrée étant fourni au multiplexeur dans différents canaux d'entrée différentiels en tant que signal de tension d'entrée échantillonné et en tant que signal d'entrée différentiel pour chaque source de signal au moyen d'un conducteur de signal (18) et d'un conducteur de référence de signal (17),

**en ce qu'**il est prévu une étape de découpage (19) formée par le multiplexeur (14) et disposée derrière le filtre d'entrée différentiel, le signal de tension d'entrée étant relié à une première entrée du multiplexeur et, de manière inversée, à une deuxième entrée du multiplexeur (14), pour réduire ou éliminer des parties de décalage de tension continue du signal de tension d'entrée en utilisant l'étape de découpage (19), et

**en ce qu'**un créateur numérique de valeur moyenne est prévu pour la création d'une valeur moyenne du signal de tension d'entrée d'échantillonnage,

une entrée supplémentaire différentielle (25) étant prévue, par l'intermédiaire de laquelle le signal de tension d'entrée court-circuite le filtre d'entrée (15) pour au moins une conversion analogique-numérique (26) d'une première valeur d'échantillonnage.

2.  Convertisseur-analogique numérique selon la revendication 1, **caractérisé en ce qu'**une étape d'addition (24) est prévue pour ajouter un signal de superposition à la valeur numérique.

3.  Convertisseur analogique-numérique selon la revendication 1 ou 2, **caractérisé en ce que** les entrées différentielles du filtre d'entrée différentiel (15) sont reliées à la masse (20), au moins une résistance à valeur élevée (R3,R4) d'au moins une des deux entrées du filtre d'entrée différentiel (15) étant de préférence reliée à la masse (20), la valeur de ladite résistance étant choisie de telle sorte que la différence de tension soit inférieure à la précision de mesure souhaitée du système.

4.  Convertisseur analogique-numérique selon l'une des revendications précédentes, **caractérisé en ce que** le filtre d'entrée différentiel (15) est associé à un filtre HF symétrique, lequel comprend au moins deux condensateurs (C3,C4), de préférence reliés à la masse (20).

5.  Convertisseur analogique-numérique selon la revendication 4, **caractérisé en ce qu'**il est prévu au moins un condensateur (C2) qui est disposé parallèlement à une source différentielle pour le signal d'entrée différentiel, la valeur du condensateur (C2) étant beaucoup plus importante que la valeur des condensateurs (C3,C4) du filtre HF symétrique et/ou le condensateur (C2) étant supérieur d'un facteur $2^x$ pour une précision souhaitée de X bits, à des condensateurs de multiplexeur $C_{mux}$ (21) connectés en série.

6.  Convertisseur analogique-numérique selon l'une des revendications précédentes, **caractérisé en ce qu'**un organe retardateur est prévu pour le retardement temporel entre le point de commutation du multiplexeur et le point d'échantillonnage du convertisseur analogique-numérique.

7.  Convertisseur analogique-numérique selon l'une des revendications précédentes, **caractérisé en ce qu'**il est prévu un filtre en peigne pour le réglage ou la régulation de la fréquence de découpage-échantillonnage, lequel filtre commande ou règle le temps de montée du multiplexeur pour la suppression ciblée de fréquences de perturbation.

8.  Convertisseur analogique-numérique selon l'une des revendications précédentes, **caractérisé en ce qu'**il est conçu pour une assistance de freinage électronique en temps réel pour véhicules automobiles basée sur un système réglé numériquement.

9.  Procédé d'évaluation de valeurs mesurées absolues à l'aide d'un convertisseur analogique-numérique, d'un microcontrôleur (10), d'un multiplexeur (14,18) et d'une topologie SAR (11) qui produit une valeur numérique momentanée sur la base d'un signal de tension d'entrée au moyen d'un emboîtement d'intervalles, et à l'aide d'un convertisseur analogique-numérique (12) qui produit une tension de référence correspondant à la valeur numérique momentanée, laquelle tension de référence étant comparée à un signal de tension d'entrée du convertisseur analogique-numérique dans un comparateur (13),

**caractérisé en ce que** le signal de tension d'entrée est fourni au multiplexeur à canaux d'entrée différentiels, pour un filtre d'entrée différentiel (15) en tant que signal de tension d'entrée échantillonné et en tant que signal d'entrée différentiel pour chaque source de signal au moyen d'un conducteur de signal (16) et d'un conducteur de référence de signal (17),

**en ce que** le signal de tension d'entrée est relié à une étape de découpage (19) formée par le multiplexeur (14,18), le signal de tension d'entrée étant relié à une première entrée du multiplexeur et, de façon inversée, à une deuxième entrée du multiplexeur, pour réduire ou éliminer les parties de décalage de tension continue du signal de tension d'entrée,

**en ce qu'**une valeur moyenne numérique est formée à partir du signal de tension d'entrée échantillonné et

**en ce que** le filtre d'entrée (15) est court-circuité pour le signal de tension d'entrée au moyen d'une entrée différentielle supplémentaire (25) pour au moins une conversion analogique-numérique (26) d'une première valeur d'échantillonnage.

10. Procédé selon la revendication 9, **caractérisé en ce qu'**un signal de superposition est ajouté à la valeur numérique.

11. Procédé selon la revendication 9 ou 10, **caractérisé en ce que** les entrées différentielles du filtre d'entrée différentiel (15) sont reliées à la masse (20).

12. Procédé selon l'une des revendications précédentes 9 à 11, **caractérisé en ce qu'**au moins une résistance de valeur élevée (R3, R4) de l'une au moins des deux entrées du filtre d'entrée différentiel (15) est reliée à la masse (20), la valeur d'une résistance au moins étant choisie de telle sorte que la différence de tension soit inférieure à la précision de mesure souhaitée du système.

13. Procédé selon l'une des revendications précédentes 9 à 12, **caractérisé en ce que** le temps entre le point de commutation du multiplexeur et le point d'échantillonnage du convertisseur analogique-numérique est retardé par un organe retardateur.

14. Procédé selon l'une des revendications précédentes à 9 à 13, **caractérisé en ce qu'**un filtre en peigne commande ou règle le temps de montée du multiplexeur pour influencer la fréquence d'échantillonnage.

15. Procédé selon l'une des revendications précédentes 9 à 14, **caractérisé en ce qu'**il est utilisé dans une assistance de freinage électronique en temps réel pour véhicules automobiles basée sur un système réglé numériquement.

Fig.1

**Fig. 2**

**Fig. 3**

**Fig. 4**

Fig. 5

Fig. 6

Fig. 7

**Fig. 8**

(Stand der Technik)     Fig. 9

Fig. 10

SAR Wandler mit Zerhacker-Stufe

11/19

Mikrocontroller

Digitales Dither Signal

25

M(z)

10

Ergebniswert

Zerhacker-Steuersignal

EP 2 286 515 B1

SAR Analog/Digital-Wandler

Start der Wandlung

Wandlung beendet

Delta-Sigma Wandler

Start der Wandlung

Wandlung beendet

**Fig. 11**

SAR Analog/Digital-Wandler

Delta-Sigma Wandler

26

t1

27

28

**Fig. 12**

SAR Analog/Digital-Wandler

1. 2. 3. 4. 5. 6. 7. 8. 9. 10.

Lt

26

Delta-Sigma Wandler

1. 2. 3. 4. 5. 6. 7. 8. 9. 10.

t1

27

28

Fig. 13

SAR Analog/Digital-Wandler  1. 2. 3. 4. 5. 6. 7. 8. 9. 10.

Lt

26

Delta-Sigma Wandler

1. 2. 3. 4. 5. 6. 7. 8. 9. 10.

t1

27

28

Fig. 14

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6927717 B1
- US 20070252747 A
- US 7049989 B2
- US 6448912 B1

**In der Beschreibung aufgeführte Nicht-Patentliteratur**

- **MCCARTNEY, D et al.** A Low-Noise Low-Drift Transducer ADC. *IEEE Journal of Solid State Circuits,* Juli 1997, vol. 32 (7), 959-967
- **ANDREAS MANGLER.** Temperaturen präzise messen. *Wekaverlag Elektronik Distribution,* Juni 2009, 16-21
- **YAZICIOGLU R F et al.** A 200 μW Eight-Channel Acquisition ASIC for AMBULATORY EEG Systems. *SOLID-STATE CIRCUITS CONFERENCE, 2008. ISSCC 2008. DIGEST OF TECHNICAL PAPERS. IEEE INTERNATIONAL,* 03. Februar 2008, ISBN 9781424450100, 164-603
- CMOS, +1.8 V to +5.5 V / ±2.5 V, 2.5 Ohm Low-voltage, 8-/16-Channel Multiplexers ADG706/ADG707. *Analog Devices,* 31. Mai 2002